(19) Europäisches Patentamt
European Patent Office
Office européen des brevets

(11) EP 4 412 428 A1

(12) EUROPEAN PATENT APPLICATION

(43) Date of publication:
**07.08.2024 Bulletin 2024/32**

(21) Application number: **24154132.5**

(22) Date of filing: **26.01.2024**

(51) International Patent Classification (IPC):
***H10K 50/165*** *(2023.01)* ***H10K 59/32*** *(2023.01)*
*H10K 85/60* *(2023.01)*

(52) Cooperative Patent Classification (CPC):
**H10K 50/165; H10K 59/32;** H10K 85/615; H10K 85/622; H10K 85/626; H10K 2101/30

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **31.01.2023 JP 2023013435**

(71) Applicant: **Canon Kabushiki Kaisha**
**Tokyo 146-8501 (JP)**

(72) Inventors:
- **SHIOBARA, Satoru**
**Tokyo, 146-8501 (JP)**
- **NISHIDE, Yosuke**
**Tokyo, 146-8501 (JP)**
- **TAKAYA, Itaru**
**Tokyo, 146-8501 (JP)**
- **NAGASHIMA, Hitoshi**
**Tokyo, 146-8501 (JP)**
- **MIHARA, Chieko**
**Tokyo, 146-8501 (JP)**

(74) Representative: **TBK**
**Bavariaring 4-6**
**80336 München (DE)**

# (54) ORGANIC LIGHT-EMITTING DEVICE, DISPLAY APPARATUS, IMAGE PICKUP APPARATUS, LIGHTING APPARATUS, AND MOVING OBJECT

(57) An organic light-emitting device (26) includes, in sequence, a first electrode (2), a first light-emitting layer (43), a charge transport layer, a charge generation portion, a second light-emitting layer (44), and a second electrode (5). The charge transport layer contains a fused polycyclic hydrocarbon compound.

FIG. 1A

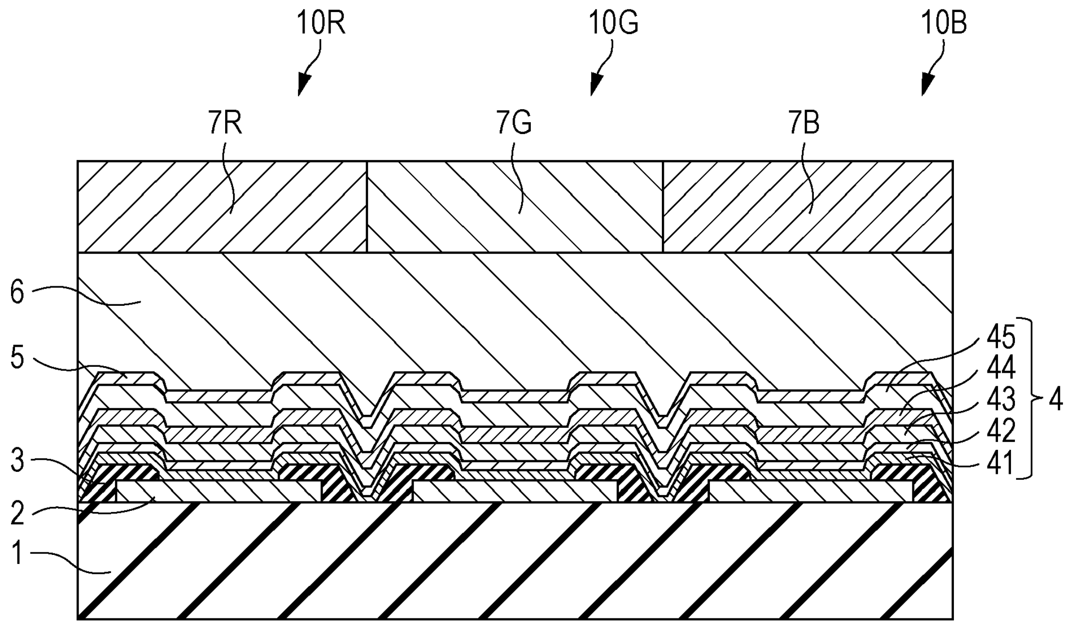




Processed by Luminess, 75001 PARIS (FR)

## Description

### BACKGROUND OF THE INVENTION

#### Field of the Invention

The present disclosure relates to an organic light-emitting device, and a display apparatus, an image pickup apparatus, a lighting apparatus, and a moving object including the organic light-emitting device.

#### Description of the Related Art

An organic light-emitting device is an electronic device including a pair of electrodes and a light-emitting layer disposed between the electrodes. Excitons generated in the light-emitting layer emit light upon returning to the ground state. Display apparatuses including organic light-emitting devices are widely known.

Among the structures of organic light-emitting devices, a tandem structure including a functional layer called a charge generation layer and multiple light-emitting layers with the charge generation layer interposed therebetween is known. The charge generation layer includes an n-type charge generation layer and a p-type charge generation layer. Carriers are supplied from the charge generation layer in addition to the electrodes, thereby improving the internal quantum efficiency.

U.S. Patent Application Publication No. 2015/144897 (PTL 1) states that holes injected from electrodes pass through a light-emitting layer and an electron transport layer, reach a charge generation layer, and recombine with electrons generated in the charge generation layer, thereby decreasing the luminous efficiency. To address this, PTL 1 discloses that the hole mobility in the electron transport layer is reduced by incorporating, for example, a salt or an organometallic complex into the electron transport layer, so that holes injected from the electrode do not easily pass through the electron transport layer, thereby reducing a decrease in luminous efficiency.

U.S. Patent Application Publication No. 2015/090984 (PTL2) states that a charge generation layer contains two types of electron transport materials in a charge generation layer, and the difference in electron injection level between the two types of electron transport materials is reduced. PTL 2 states that this improves the electron injection properties from the charge generation layer to the adjacent electron transport layer, thereby improving the luminous efficiency of the organic light-emitting device.

In the organic light-emitting device described in PTL 1, since the hole mobility in the electron transport layer is reduced, the holes easily remain in the electron transport layer to increase holes that recombine in the electron transport layer. This results in an electron transport layer that is susceptible to deterioration due to energization.

The organic light-emitting device described in PTL 2 contains two types of electron transport materials in the charge generation layer containing an n-type dopant, but there is no description about a component material of a charge transport layer adjacent to the charge generation layer.

### SUMMARY OF THE INVENTION

The present disclosure provides a technique advantageous for the configuration of a tandem organic light-emitting device having a long operating lifetime.

The present disclosure in its first aspect provides an organic light-emitting device as specified in Claims 1 to 15.

Further features of the present disclosure will become apparent from the following description of exemplary embodiments with reference to the attached drawings.

### BRIEF DESCRIPTION OF THE DRAWINGS

Fig. 1A illustrates a layer structure of an organic light-emitting device according to an embodiment of the present disclosure.

Fig. 1B is a schematic cross-sectional view of an example of a display apparatus including organic light-emitting devices according to an embodiment of the present disclosure and transistors electrically coupled to the respective organic light-emitting devices.

Fig. 2 is a schematic view of an example of a display apparatus according to an embodiment of the present disclosure.

Fig. 3A is a schematic view of an example of an image pickup apparatus according to an embodiment of the present disclosure. Fig. 3B is a schematic view of an example of a portable apparatus according to an embodiment of the present disclosure.

Fig. 4A is a schematic view of an example of a display apparatus according to an embodiment of the present disclosure. Fig. 4B is a schematic view of an example of a foldable display apparatus.

Fig. 5A is a schematic view of an example of a lighting apparatus according to an embodiment of the present disclosure. Fig. 5B is a schematic view of an automobile as an example of a moving object according to an embodiment of the present disclosure.

Fig. 6A is a schematic view illustrating an example of a wearable device according to an embodiment of the present disclosure, and Fig. 6B is a schematic view of an example of a wearable device according to an embodiment of the present disclosure, the wearable device including an image pickup apparatus.

Fig. 7A is a schematic view of an image-forming apparatus according to an embodiment of the present disclosure. Figs. 7B and 7C are schematic views each illustrating a configuration of an exposure light source of an image-forming apparatus according to an embodiment of the present disclosure.

Fig. 8 is a view illustrating an emission spectrum when the organic light-emitting devices produced in Example 1 and Comparative Example 1 were driven.

Fig. 9 is a graph illustrating the relationship between luminance and time when the organic light-emitting devices produced in Example 1 and Comparative Example 1 were driven.

DESCRIPTION OF THE EMBODIMENTS

In an embodiment of the present disclosure, an organic light-emitting device includes, in sequence, a first electrode, a first light-emitting layer, a charge transport layer, a charge generation portion, a second light-emitting layer, and a second electrode, in which the charge transport layer contains a fused polycyclic hydrocarbon compound.

An organic light-emitting device according to an embodiment of the present disclosure includes a first light-emitting layer, a second light-emitting layer, and a charge generation portion interposed between the first and second light-emitting layers. This is what is called a tandem light-emitting device.

The inventors have found that when a charge transport layer containing a fused polycyclic hydrocarbon compound is provided between a light-emitting layer and a charge generation portion, the operating lifetime of a tandem organic light-emitting device is significantly improved.

In the organic light-emitting device according to an embodiment of the present disclosure, the deterioration of the charge generation portion is improved by the use of the charge transport layer containing the fused polycyclic hydrocarbon compound, thereby resulting in a long operating lifetime of the device. This is mainly because the n-type charge generation layer having an n-dopant in the charge generation portion is not deteriorated by driving. Hitherto, an n-type charge generation layer containing an n-dopant has contained a polar skeleton, such as 1,10-phenanthroline, as a main component; thus, the n-dopant has diffused into the charge transport layer. This diffusion decreases in the operating lifetime of the organic light-emitting device. The term "main component" used here refers to a compound that constitutes the largest proportion by weight in the layer.

In contrast, in the organic light-emitting device according to an embodiment of the present disclosure, a layer with low polarity is disposed between the n-type charge generation layer containing an n-dopant and the light-emitting layer, thereby reducing the diffusion of the n-dopant into the charge transport layer. This enables the n-dopant to remain in the charge generation portion, thereby reducing performance deterioration during the charge generation process and the charge injection/transport process. At this time, a fused polycyclic hydrocarbon compound can be used as a compound that transports charges and reduces the diffusion of the n-dopant.

In an embodiment of the present disclosure, the fused polycyclic hydrocarbon compound can be contained in the charge transport layer. For example, the charge transport layer may be composed of only the fused polycyclic hydrocarbon compound, or may contain a compound in addition to the fused polycyclic hydrocarbon compound. The charge transport layer containing the fused polycyclic hydrocarbon compound can be in direct contact with the charge generation portion, and may include a layer composed of a charge transport material containing a polar skeleton.

In an embodiment of the present disclosure, the charge transport layer may be an electron transport layer or a hole transport layer. In an embodiment of the present disclosure, an example in which the compound is used in an electron transport layer will be described below, but the present disclosure is not limited thereto. The charge transport layer is called a hole transport layer when disposed between the light-emitting layer and an electrode for injecting holes, and is called an electron transport layer when disposed between the light-emitting layer and an electrode for injecting electrons.

The fused polycyclic hydrocarbon compound according to the present embodiment may have electron transport properties. The fact that the fused polycyclic hydrocarbon compound has the electron transport properties indicates that the electron mobility is higher than the hole mobility of the fused polycyclic hydrocarbon compound.

In this specification, the charge generation portion may include an n-type charge generation layer and a p-type organic semiconductor layer. An n-type organic semiconductor layer containing a compound having a lowest-unoccupied-molecular-orbital (LUMO) energy level of -5.0 eV or less may be disposed between the n-type charge generation layer

and the p-type charge generation layer. The n-type organic semiconductor layer may contain a radialene compound, HAT-CN, or the like. The p-type organic semiconductor layer may also serve as a hole transport layer that transports holes to the second light-emitting layer.

Table 1 presents an example of the structure of a tandem organic light-emitting device including two light-emitting units.

The charge generation portion according to an embodiment of the present disclosure includes an electron injection layer [n-type charge generation layer]/hole injection layer [n-type organic semiconductor layer]/hole transport layer 2 [p-type organic semiconductor layer]. The charge generation portion generates pairs of charges, i.e., electrons and holes, as internal charges. The electron is transported to the first light-emitting layer through the electron transport layer 1. The hole is transported to the second light-emitting layer through the hole transport layer 2. These internally generated charges recombine with holes and electrons injected from the outer electrode to generate excitons, thereby emitting light.

Table 1

| Unit | Layer name |
|---|---|
| Cathode | Cathode |
| | Electron injection layer 2 |
| Light-emitting unit 2 | Electron transport layer 2 |
| | Hole-blocking layer 2 |
| | Second light-emitting layer |
| | Electron-blocking layer 2 |
| Charge generation region | Hole transport layer 2 [p-type organic semiconductor layer] |
| | Hole injection layer 2 [n-type organic semiconductor layer] |
| | Electron injection layer 1 [n-charge generation layer] |
| Light-emitting unit 1 | Electron transport layer 1 |
| | Hole-blocking layer 1 |
| | First light-emitting layer |
| | Electron-blocking layer 1 |
| | Hole transport layer 1 |
| | Hole injection layer 1 |
| Anode | Anode |

The charge transport layer according to the present embodiment may contain a charge transport material in addition to the fused polycyclic hydrocarbon compound. The charge transport material can be a polar skeleton-containing charge transport material. In the present embodiment, the electron transport layer 1 contains the fused polycyclic hydrocarbon compound and an electron transport material.

The electron transport material used here can be referred to as a first charge transport material. The first charge transport material according to the present embodiment is an electron transport material and thus can also be referred to as a first electron transport material. Examples of the first charge transport material include oxadiazole derivatives, oxazole derivatives, pyrazine derivatives, triazole derivatives, triazine derivatives, quinoline derivatives, quinoxaline derivatives, phenanthroline derivatives, and organoaluminum complex.

The charge transport layer according to an embodiment of the present disclosure contains the first charge transport material and thus rapidly injects electrons into an adjacent organic layer, thereby reducing the deterioration of the charge transport layer due to energization. This is because electrons can be rapidly injected into another layer, thereby reducing recombination in the charge transport layer.

In the n-type charge generation layer, similarly, electrons can be rapidly injected into another layer. An unstable portion of the tandem organic light-emitting device is an n-doped charge generation portion, that is, the n-type charge generation layer; thus, the effect is even more significant. In the charge generation portion, the Fermi level of the n-dopant contained in the n-type charge generation layer and the Fermi level in the p-type charge generation layer cause band bending at the junction, thereby injecting electrons from the p-type charge generation layer into the n-type charge

generation layer. The electrons pass through the n-type charge generation layer and are injected into the adjacent electron transport layer 1. In a long-life tandem organic light-emitting device, deterioration of the electron injection properties during long-term operation can be inhibited. In addition, the generated electrons can be rapidly injected from the n-type charge generation layer into the electron transport layer 1. This is to reduce recombination in the n-type charge generation layer, thereby reducing the deterioration of the n-type charge generation layer due to energization.

The configuration of the organic light-emitting device according to an embodiment of the present disclosure will be described below.

(1) Charge Transport Layer Contains Fused polycyclic hydrocarbon compound.

In the present embodiment, the charge transport layer is the electron transport layer 1. The fused polycyclic hydrocarbon compound is a compound having a molecular structure free of a polar skeleton. The incorporation of the fused polycyclic hydrocarbon compound in the electron transport layer 1 can reduce the polarity of the electron transport layer. The n-dopant cannot be stably present in the electron transport layer having reduced polarity, so that the diffusibility of the n-dopant into the electron transport layer 1 is reduced. This is effective in reducing the diffusion of the n-dopant from the adjacent n-charge generation layer. A reduction in the diffusion of the n-dopant can reduce a decrease in the electron injection performance of the n-charge generation layer. This is because the diffusion of n-dopant is reduced and its concentration is not changed, thereby reducing a change in the energy level of the n-charge generation layer. This results in a small change in the charge transport performance of the charge transport layer, thus leading to a small change in the luminance of the light-emitting unit 1. That is, rapid deterioration of the light-emitting unit 1 can be reduced.

The term "polar skeleton" used here refers to a skeleton having a heteroatom, such as a nitrogen atom, an oxygen atom, or a sulfur atom, in the structure.

The organic light-emitting device according to an embodiment of the present disclosure contains the fused polycyclic hydrocarbon compound in the form of a single layer or a mixture layer. The layer containing the fused polycyclic hydrocarbon compound can be adjacent to the charge generation portion.

The fused polycyclic hydrocarbon compound according to the present embodiment is, for example, a compound including benzene, naphthalene, fluorene, phenanthrene, triphenylene, anthracene, pyrene, chrysene, spirofluorene, or a derivative thereof. In consideration of stability, the fused polycyclic hydrocarbon compound may have a structure in which benzene, naphthalene, fluorene, phenanthrene, triphenylene, anthracene, pyrene, chrysene, and spirofluorene are combined. Examples of the compound are illustrated below, but the present disclosure is not limited thereto.

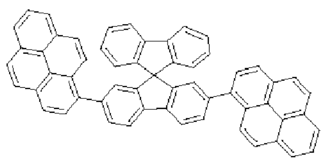

ETM2-1

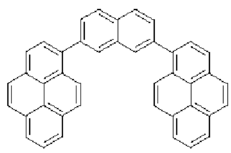

ETM2-8

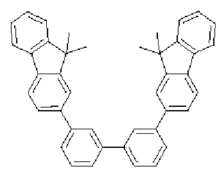

ETM2-15

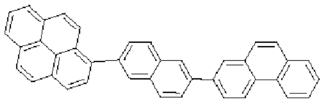

ETM2-2

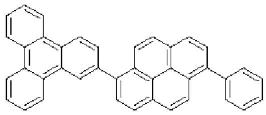

ETM2-9

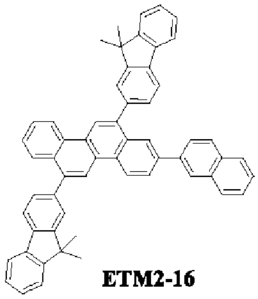

ETM2-16

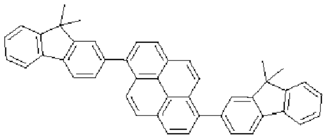

ETM2-3

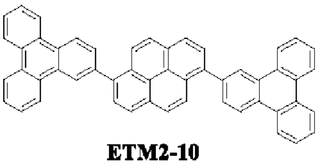

ETM2-10

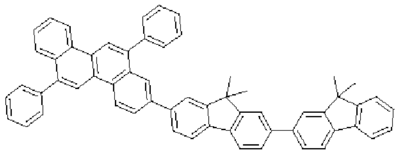

ETM2-17

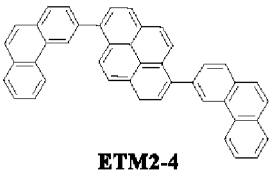

ETM2-4

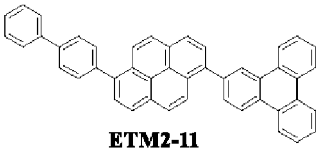

ETM2-11

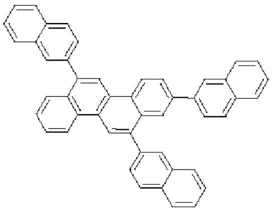

ETM2-18

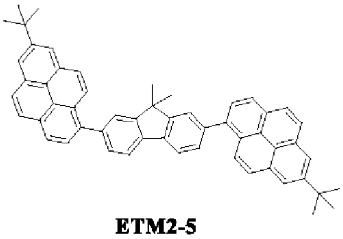

ETM2-5

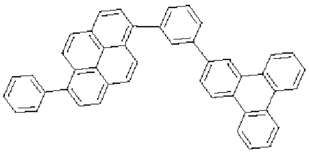

ETM2-12

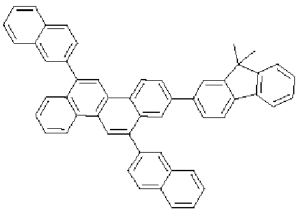

ETM2-19

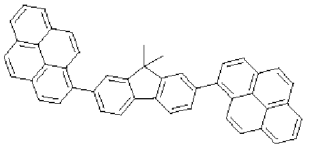

ETM2-6

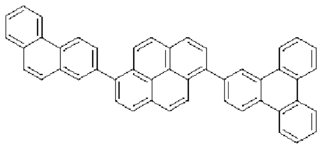

ETM2-13

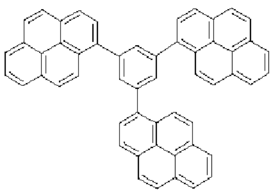

ETM2-7

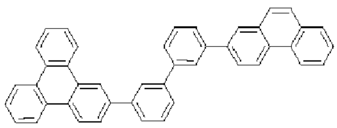

ETM2-14

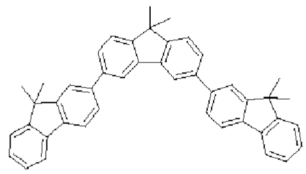

ETM2-20

Among the above exemplified compounds, like ETM2-5, a structure in which an alkyl group, such as a tert-butyl group, is attached as a substituent may be used. Among the exemplified compounds, a compound having a pyrene skeleton or a chrysene skeleton can be used. The compound having a pyrene skeleton or a chrysene skeleton may have a substituent in addition to the pyrene or chrysene moiety. The substituent may be an aryl group or an alkyl group. The substituent can be free of a heteroatom.

(2) Charge Mobility Is High

The fused polycyclic hydrocarbon compound (second charge transport material) according to an embodiment of the present disclosure can be a material having high mobility. Improving the electron transport properties of the electron

transport layer 1 can reduce the deterioration of the electron transport material. This is because the amount of recombination of electrons and holes leaking from the light-emitting layer can be reduced in the electron transport material. Improving the electron transport properties of the electron transport layer 1 can reduce the driving voltage of the organic light-emitting device. When hole leakage occurs, a conventional electron transport material, for example, the first electron transport material is easily deteriorated by energization, compared with the fused polycyclic hydrocarbon compound. This is due to the fact that when the electron transport material comes into contact with holes, the electron transport material is in a cation radical state, which is chemically unstable.

(3) Difference Between LUMO Energy Levels of Two Electron Transport Materials Is Small.

The energy difference (|ΔLUMO|) between the lowest unoccupied molecular orbital (LUMO) of the fused polycyclic hydrocarbon compound (second charge transport material) according to the present embodiment and the LUMO of the first charge transport material can be small in order to improve the mobility. When the energy difference is large, it takes a long time for trapping and detrapping, thus reducing the effect due to the improved electron mobility. In order not to reduce the effect due to the improved electron mobility, |ΔLUMO| can be 0.1 eV or less. In the case of controlling the mobility of holes, the above relationship can be used for the highest occupied molecular orbital (HOMO) instead of LUMO.

(4) Both (2) and (3) Are Satisfied.

The effect due to the improved mobility can be maximized by selecting the second charge transport material having a high mobility in the requirement described in (2) in such a manner that |ΔLUMO| between the second charge transport material and the first charge transport material is small.

(5) Nonpolar Charge Transport Material Is Contained in N-Type Charge Generation Layer.

When a nonpolar charge transport material (fourth charge transport material) is contained in the n-type charge generation layer, the degree of polarity of the n-type charge generation layer can be lowered. When the degree of polarity of the n-type charge generation layer is lowered, an alkali metal, such as Li, does not easily diffuse. This can reduce a deterioration in electron injection properties due to the diffusion of the alkali metal into the adjacent layer. Examples of the fourth charge transport material include ETM2-1 to ETM2-20.

(6) Fourth Charge Transport Material Is the Same Material as Second Charge Transport Material.

The second charge transport material and the fourth charge transport material can be the same compound. This is because an injection barrier from the n-type charge generation layer to the electron transport layer 1 can be reduced. A reduction in this injection barrier can reduce the time during which electrons remain in the n-type charge generation layer, thereby reducing the number of electrons that recombine in the n-type charge generation layer. The n-type charge generation layer that is less susceptible to recombination energy does not easily deteriorate.

(7) Proportion by Weight of Second Charge Transport Material in Electron Transport Layer 1 Is Substantially the Same as Proportion By Weight of Fourth Charge Transport Material in N-Type Charge Generation Layer.

The organic layers of the organic light-emitting device according to an embodiment of the present disclosure can be continuously formed in the same chamber. In particular, the electron transport layer 1 and the n-type charge generation layer may be continuously formed in the same chamber. At this time, when the film is formed using the same vapor deposition sources, the ratio by concentration of the first charge transport material to the second charge transport material and the ratio by concentration of the third charge transport material to the fourth charge transport material are substantially the same, and the film formation state is substantially the same. Thus, the films are stable. Furthermore, the film formation process can be performed only by opening and closing a source shutter for depositing the n-dopant. That is, it is not necessary to change the rate or to convey a substrate to another chamber; thus, the time required for forming the electron transport layer 1 and the n-charge generation layer can be minimized. Thus, the cost can also be reduced.

The term "substantially the same" used here refers to tolerating the degree of difference that occurs even when films are formed under the same conditions. In particular, the difference may be within 2% by weight. The proportions by weight can be the same.

(8) Light-Emitting Layer of Light-Emitting Unit 1 Is Electron-Trap Type.

The structure of the organic light-emitting device according to an embodiment of the present disclosure is more effective when holes easily leak from the light-emitting layer. This is related to reasons (2) to (4). For example, when the first light-emitting layer is a blue light-emitting layer, an electron- or hole-trap-type light-emitting dopant is selected. Carriers to be trapped are less likely to cause carrier leakage. That is, holes easily leak in the electron-trap type, and electrons easily leak in the hole-trap type. The organic light-emitting device according to an embodiment of the present disclosure has the effect of reducing deterioration due to holes leaking from the light-emitting layer and thus provides a greater effect in an electron-trap type in which holes easily leak. Thus, the effect according to an embodiment of the present disclosure tends to be greater in the case of the electron trap-type light-emitting layer than in the case of the hole trap-type light-emitting material.

(9) Proportion by Weight of Fused polycyclic hydrocarbon compound in Electron Transport Layer 1 Is 10% or More by Weight.

The proportion by weight of the fused polycyclic hydrocarbon compound in the electron transport layer of the organic light-emitting device according to an embodiment of the present disclosure can be 10% or more by weight in order to transport electrons. Here, the proportion by weight of the fused polycyclic hydrocarbon compound may be determined with respect to 100% by weight of the total weight of the organic compounds contained in the electron transport layer 1. The proportion by weight may be determined by, for example, LC/MS/MS. When each layer, such as the electron transport layer, has a uniform composition, the proportion by weight of the compound in the entire layer may be estimated by measuring the compound in a portion of the electron transport layer.

(10) Fourth Charge Transport Material Contained In N-Type Charge Generation Layer Is 10% or More by Weight.

The proportion by weight of the fourth electron transport material in the n-type charge generation layer of the organic light-emitting device according to an embodiment of the present disclosure can be 10% or more by weight because the fourth electron transport material serves to transport electrons. The measurement of the proportion by weight is the same as in item (9).

(11) Emission Color of Light-Emitting Layer of Item (8) Is Blue.

An organic light-emitting device having a blue light-emitting layer has a short operating lifetime; thus, the combination with the present disclosure is particularly effective in improving the operating lifetime.

The requirements of the organic light-emitting device according to an embodiment of the present disclosure have been described above. For example, in order to further increase the luminous efficiency with respect to the driving current, a charge generation portion 1 and a light-emitting unit 3 may be disposed between the light-emitting unit 2 and the cathode. In this case, the hole injection layer 2 can be an n-type semiconductor layer similar to the hole injection layer 1. As the electron injection layer 2, an n-charge generation layer similar to the electron injection layer 1 can be used. Like the electron transport layer 1 according to an embodiment of the present disclosure, the electron transport layer 2 can include a first electron transport layer and a second electron transport layer.

Next, an organic light-emitting device according to an embodiment of the present disclosure will be described. An organic light-emitting device according to an embodiment of the present disclosure includes a first electrode, a second electrode, and an organic compound layer disposed between these electrodes. One of the first electrode and the second electrode is an anode, and the other is a cathode. In the organic light-emitting device according to the present embodiment, the organic compound layer may be formed of a single layer or a laminate including multiple layers, as long as it includes a light-emitting layer. When the organic compound layer is formed of a laminate including multiple layers, the organic compound layer may include, in addition to the light-emitting layer, a hole injection layer, a hole transport layer, an electron-blocking layer, a hole-exciton-blocking layer, an electron transport layer, and an electron injection layer, for example. The light-emitting layer may be formed of a single layer or a laminate including multiple layers. In the case of providing multiple light-emitting layers, a charge generation layer may be disposed between the light-emitting layers. The charge generation layer may be composed of a compound having a LUMO level lower than the hole transport layer, and the LUMO level of the charge generation layer may be lower than the HOMO level of the hole transport layer. Here, the molecular orbital energy level of the organic compound layer may be the molecular orbital energy level of the organic compound having the largest proportion by weight in the organic compound layer.

Here, the HOMO level and the LUMO level are described as "higher" as they are closer to the vacuum level. The fact that LUMO level of the charge generation layer is lower than the HOMO level of the hole transport layer indicates that the LUMO level of the charge generation layer is closer to the vacuum level than the HOMO level of the hole transport

layer.

In this specification, HOMO and LUMO can be calculated by molecular orbital calculation. As the molecular orbital calculation method, the density functional theory (DFT) may be used with the B3LYP functional and 6-3 1 G* as the basis function, for example. The molecular orbital calculation method was performed using Gaussian 09 (Gaussian 09, Revision C.01, M.J. Frisch, G.W. Trucks, H.B. Schlegel, G.E. Scuseria, M.A. Robb, J.R. Cheeseman, G. Scalmani, V. Barone, B. Mennucci, G.A. Petersson, H. Nakatsuji, M. Caricato, X. Li, H.P. Hratchian, A.F. Izmaylov, J. Bloino, G. Zheng, J.L. Sonnenberg, M. Hada, M. Ehara, K. Toyota, R. Fukuda, J. Hasegawa, M. Ishida, T. Nakajima, Y. Honda, O. Kitao, H. Nakai, T. Vreven, J.A. Montgomery, Jr., J.E. Peralta, F. Ogliaro, M. Bearpark, J.J. Heyd, E. Brothers, K.N. Kudin, V.N. Staroverov, T. Keith, R. Kobayashi, J. Normand, K. Raghavachari, A. Rendell, J.C. Burant, S.S. Iyengar, J. Tomasi, M. Cossi, N. Rega, J.M. Millam, M. Klene, J.E. Knox, J.B. Cross, V. Bakken, C. Adamo, J. Jaramillo, R. Gomperts, R.E. Stratmann, O. Yazyev, A.J. Austin, R. Cammi, C. Pomelli, J.W. Ochterski, R.L. Martin, K. Morokuma, V.G. Zakrzewski, G.A. Voth, P. Salvador, J.J. Dannenberg, S. Dapprich, A.D. Daniels, O. Farkas, J.B. Foresman, J.V. Ortiz, J. Cioslowski, and D.J. Fox, Gaussian, Inc., Wallingford CT, 2010).

The HOMO and LUMO levels in this specification can be calculated using an ionization potential and a band gap. A HOMO level can be estimated by measuring an ionization potential. The ionization potential can be measured by dissolving a target compound in a solvent, such as toluene, and performing measurement with a measurement apparatus, such as AC-3. The band gap can be measured by dissolving a target compound in a solvent, such as toluene, and then irradiating the resulting solution with excitation light. The band gap can be measured by measuring the absorption edge of the excitation light. Alternatively, the measurement can be performed by depositing a target compound using vapor deposition on a substrate, such as a glass substrate, and irradiating the resulting film with excitation light. The band gap can be measured by measuring the absorption edge of the absorption spectrum of the film when the film absorbs the excitation light.

The LUMO level can be calculated using the values of the band gap and the ionization potential. The LUMO level can be estimated by subtracting the value of the ionization potential from the value of the band gap.

The LUMO level can also be estimated from a reduction potential. For example, a one-electron reduction potential is estimated by cyclic voltammetry (CV) measurement. The CV measurement can be performed, for example, in a 0.1 M solution of tetrabutylammonium perchlorate in DMF using $Ag/Ag^+$ as a reference electrode, Pt as a counter electrode, and glassy carbon as a working electrode. The LUMO level can be estimated by adding -4.8 eV to the difference between the reduction potential of the obtained compound and the reduction potential of ferrocene.

In the organic light-emitting device according to an embodiment of the present disclosure, when the organic compound according to the present embodiment is contained in a light-emitting layer, the light-emitting layer may be composed only of the organic compound according to the present embodiment or may be composed of an organometallic complex according to the present embodiment and another compound. When the light-emitting layer is composed of the organometallic complex according to the present embodiment and another compound, the organic compound according to the present embodiment may be used as a host or a guest of the light-emitting layer. The organic compound according to the present embodiment may be used as an assist material that can be contained in the light-emitting layer. The term "host" used here refers to a compound having the largest proportion by mass in compounds contained in the light-emitting layer. The term "guest" refers to a compound that has a lower proportion by mass than the host in the compounds contained in the light-emitting layer and that is responsible for main light emission. The term "assist material" refers to a compound that has a lower proportion by mass than the host in the compounds contained in the light-emitting layer and that assists the light emission of the guest. The assist material is also referred to as a second host. The host material may be referred to as the "first compound". The assist material may be referred to as a "second compound".

When the organic compound according to an embodiment of the present disclosure is used as a guest in the light-emitting layer, the concentration of the guest is preferably 0.01% or more by mass and 20% or less by mass, more preferably 0.1% or more by mass and 10% or less by mass, based on the entire light-emitting layer. The guest is also referred to as a "dopant".

The inventors have conducted various studies and have found that when the organic compound according to the present embodiment is used as a host or guest of a light-emitting layer, especially as a guest of a light-emitting layer, a device that emits light with high efficiency and high luminance and that is extremely durable can be provided. This light-emitting layer can be formed of a single layer or multiple layers and can also contain a light-emitting material having another emission color in order to conduct the color mixture of the red emission color of the present embodiment and another emission color. The term "multiple layers" refers to a state in which a light-emitting layer and another light-emitting layer are stacked. In this case, the emission color of the organic light-emitting device is not limited to red. More specifically, the emission color may be white or an intermediate color. In the case of white, another light-emitting layer emits light of a color other than red, that is, blue or green. A film-forming method is vapor deposition or coating. Details will be described in examples below.

The organometallic complex according to the present embodiment can be used as a component material of an organic compound layer other than the light-emitting layer included in the organic light-emitting device according to

the embodiment. Specifically, the organometallic complex may be used as a component material of the electron transport layer, the electron injection layer, the hole transport layer, the hole injection layer, the hole-blocking layer, and so forth. In this case, the emission color of the organic light-emitting device is not limited to red. More specifically, the emission color may be white or intermediate color.

For example, a hole injection compound, a hole transport compound, a compound to be used as a host, a light-emitting compound, an electron injection compound, or an electron transport compound, which is known and has a low or high molecular weight, can be used together with the organic compound according to the present embodiment, as needed. Examples of these compounds are illustrated below.

As a hole injection-transport material, a material having a high hole mobility can be used so as to facilitate the injection of holes from the anode and to transport the injected holes to the light-emitting layer. To reduce a deterioration in film quality, such as crystallization, in the organic light-emitting device, a material having a high glass transition temperature can be used. Examples of a low- or high-molecular-weight material having the ability to inject and transport holes include triarylamine derivatives, aryl carbazole derivatives, phenylenediamine derivatives, stilbene derivatives, phthalocyanine derivatives, porphyrin derivatives, poly(vinyl carbazole), polythiophene, and other conductive polymers. Moreover, the hole injection-transport material can also be used for the electron-blocking layer. Non-limiting specific examples of a compound used as the hole injection-transport material will be illustrated below.

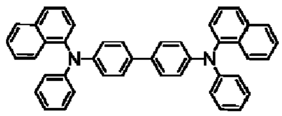
HT1

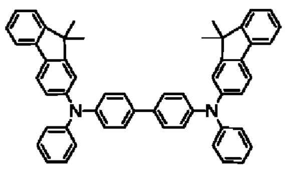
HT2

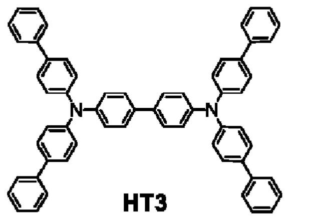
HT3

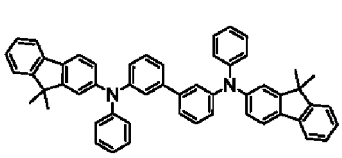
HT4

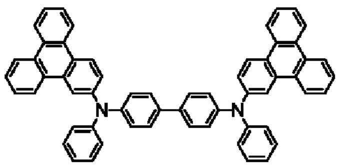
HT5

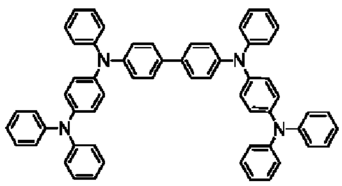
HT6

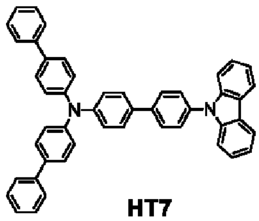
HT7

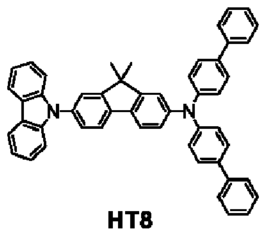
HT8

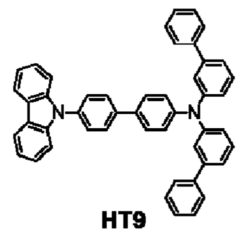
HT9

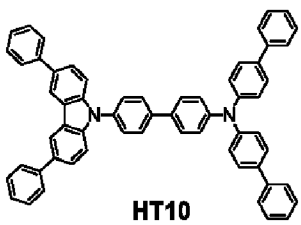
HT10

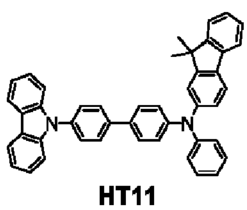
HT11

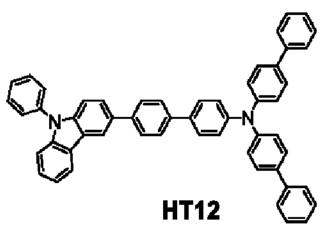
HT12

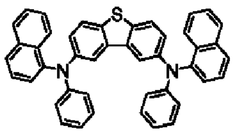

HT13

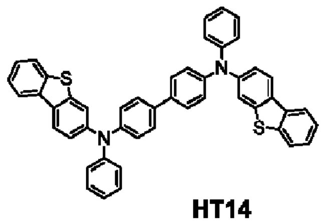

HT14

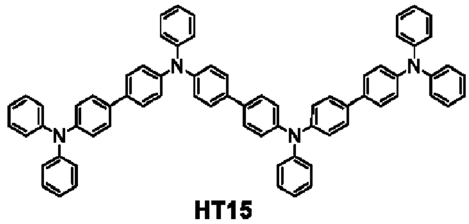

HT15

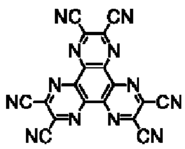

HT16

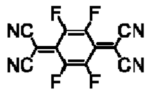

HT17

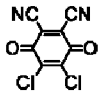

HT18

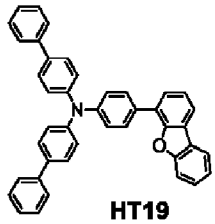

HT19

Among the hole transport materials illustrated above, HT16 to HT18 can be used in the layer in contact with the anode to reduce the driving voltage. HT16 is widely used in organic light-emitting devices. HT2, HT3, HT4, HT5, HT6, HT10, and HT12 may be used in an organic compound layer adjacent to HT16. Multiple materials may be used in a single organic compound layer.

Examples of a light-emitting material mainly associated with a light-emitting function include fused-ring compounds, such as fluorene derivatives, naphthalene derivatives, pyrene derivatives, perylene derivatives, tetracene derivatives, anthracene compounds, and rubrene, quinacridone derivatives, coumarin derivatives, stilbene derivatives, organoaluminum complexes, such as tris(8-quinolinolato)aluminum, iridium complexes, platinum complexes, rhenium complexes, copper complexes, europium complexes, ruthenium complexes, and polymer derivatives, such as poly(phenylene vinylene) derivatives, polyfluorene derivatives, and polyphenylene derivatives.

Non-limiting specific examples of a compound used as a light-emitting material are described below.

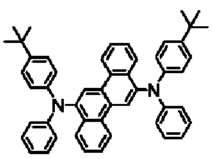

BD1

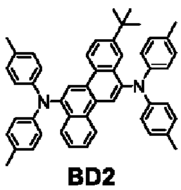

BD2

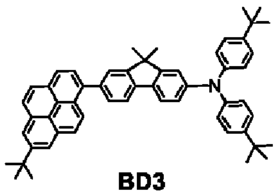

BD3

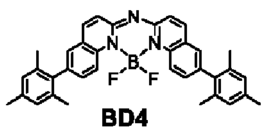

BD4

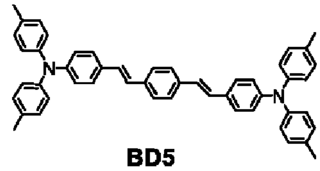

BD5

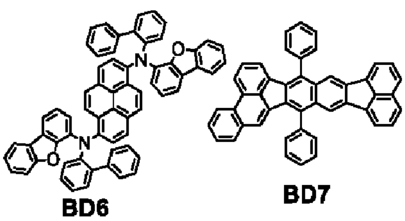

BD6

BD7

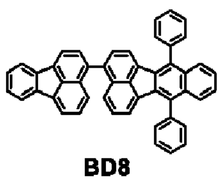

BD8

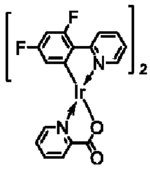

BD9

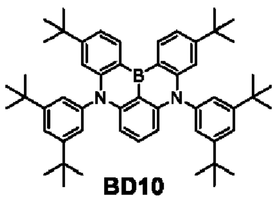

BD10

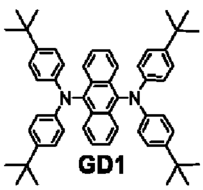
GD1

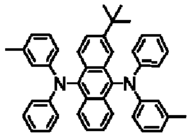
GD2

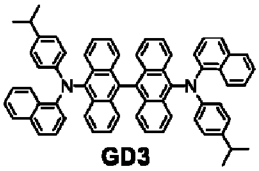
GD3

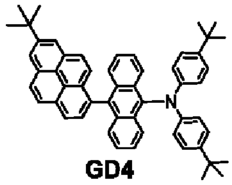
GD4

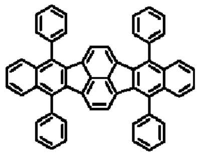
GD5

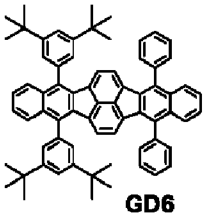
GD6

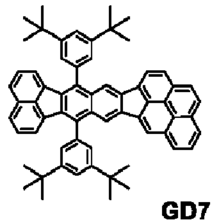
GD7

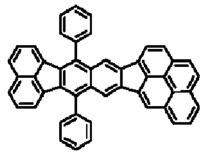
GD8

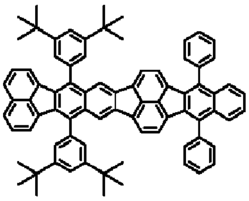
GD9

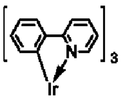
GD10

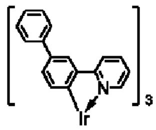
GD11

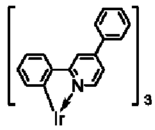
GD12

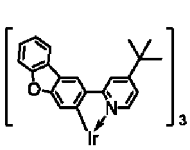
GD13

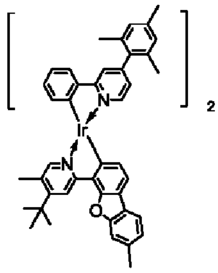
GD14

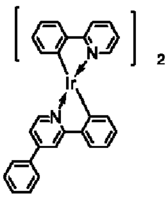
GD15

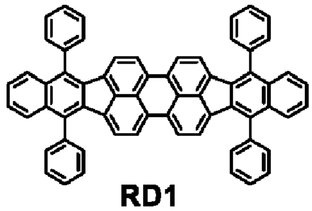
RD1

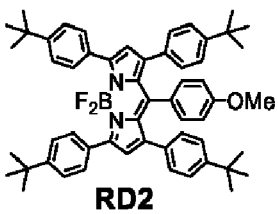
RD2

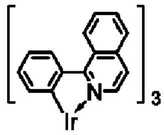
RD3

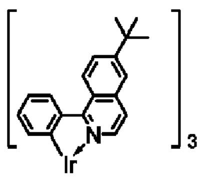
RD4

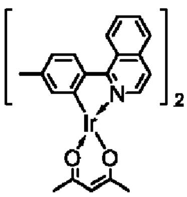
RD5

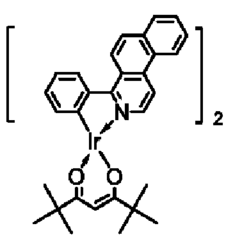
RD6

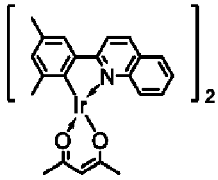
RD7

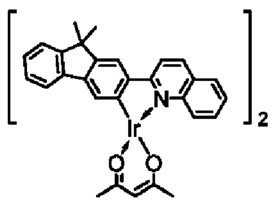
RD8

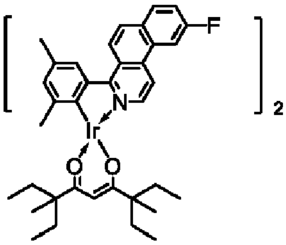

**RD9**

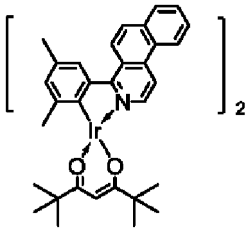

**RD10**

When the light-emitting material is a hydrocarbon compound, the material can reduce a decrease in luminous efficiency due to exciplex formation and a decrease in color purity due to a change in the emission spectrum of the light-emitting material caused by exciplex formation.

The hydrocarbon compound is a compound consisting only of carbon and hydrogen. Among the above exemplified compounds, BD7, BD8, GD5 to GD9, and RD1 are hydrocarbon compounds.

When the light-emitting material is a fused polycyclic compound containing a five-membered ring, the material has a high ionization potential and high resistance to oxidation. This can provide a highly durable device with a long lifetime. Among the above exemplified compounds, BD7, BD8, GD5 to GD9, and RD1 are five-membered-ring-containing fused polycyclic compounds.

Examples of a host or an assist material in the light-emitting layer include aromatic hydrocarbon compounds and derivatives thereof, carbazole derivatives, dibenzofuran derivatives, dibenzothiophene derivatives, organoaluminum complexes, such as tris(8-quinolinolato)aluminum, and organoberyllium complexes.

Non-limiting specific examples of a compound used as a light-emitting-layer host or an assist material contained in the light-emitting layer will be illustrated below.

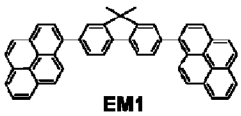

**EM1**

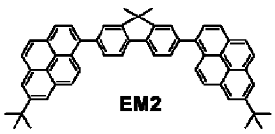

**EM2**

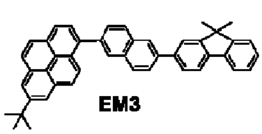

**EM3**

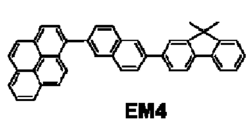

**EM4**

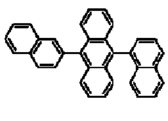

**EM5**

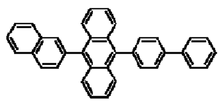

**EM6**

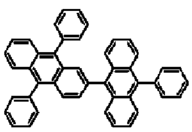

**EM7**

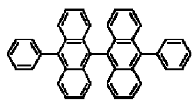

**EM8**

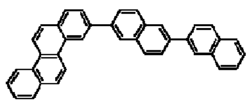

**EM9**

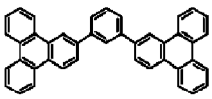

**EM10**

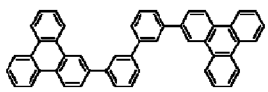

**EM11**

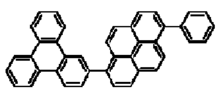

**EM12**

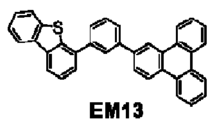

**EM13**

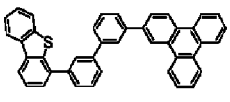

**EM14**

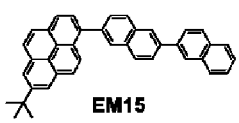

**EM15**

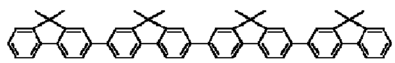

**EM16**

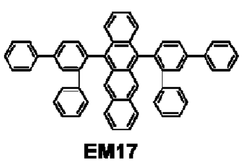

**EM17**

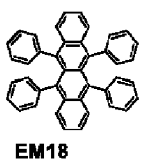

**EM18**

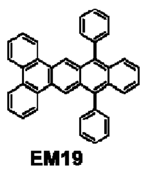

**EM19**

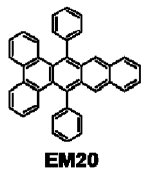

**EM20**

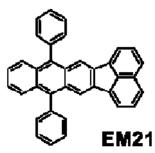

**EM21**

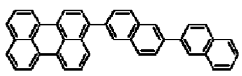
EM22

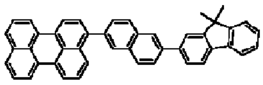
EM23

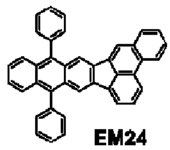
EM24

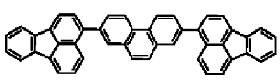
EM25

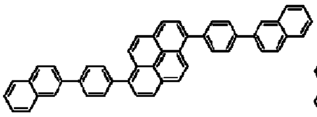
EM26

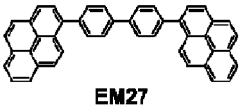
EM27

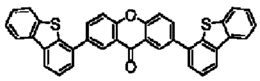
EM28

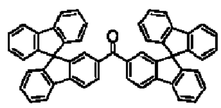
EM29

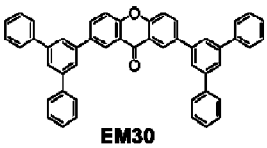
EM30

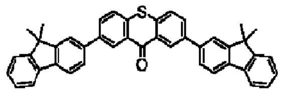
EM31

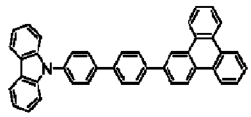
EM32

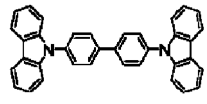
EM33

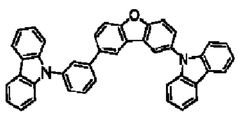
EM34

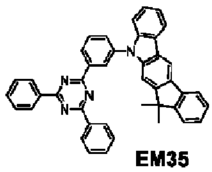
EM35

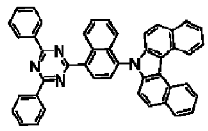
EM36

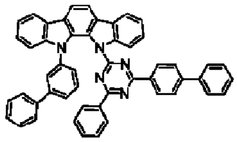
EM37

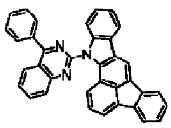
EM38

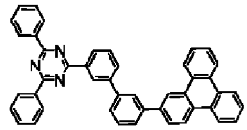
EM39

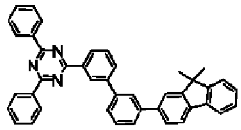
EM40

The host material can be a hydrocarbon compound. The hydrocarbon compound is a compound consisting only of carbon and hydrogen. Among the above exemplified compounds, EM1 to EM12 and EM16 to EM27 are hydrocarbon compounds. As the host material, a material having no carbon-heteroatom bond in the single bond connecting the aryl group units in the structure can be used from the viewpoint of stability.

The electron transport material can be freely-selected from materials that can transport electrons injected from the cathode to the light-emitting layer, and is selected in consideration of, for example, the balance with the hole mobility of the hole transport material. Examples of a material having the ability to transport electrons include oxadiazole derivatives, oxazole derivatives, pyrazine derivatives, triazole derivatives, triazine derivatives, quinoline derivatives, quinoxaline derivatives, phenanthroline derivatives, organoaluminum complexes, and fused-ring compounds, such as fluorene derivatives, naphthalene derivatives, chrysene derivatives, and anthracene derivatives. The electron transport materials can also be used for the hole-blocking layer.

Non-limiting examples of a compound used as the electron transport material will be specifically described below.

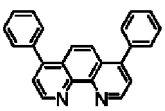
ET1

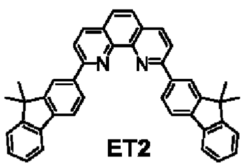
ET2

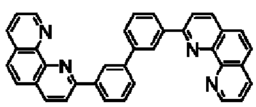
ET3

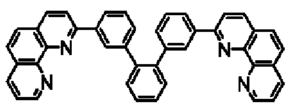
ET4

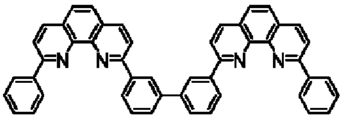 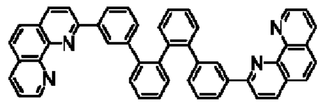 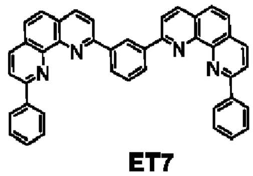

ET5 ET6 ET7

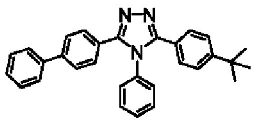 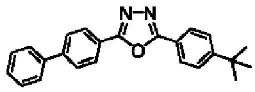 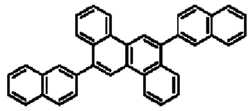 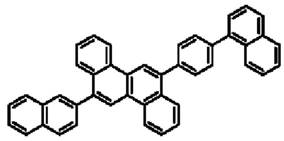

ET8 ET9 ET10 ET11

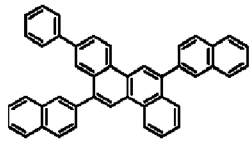 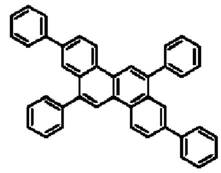 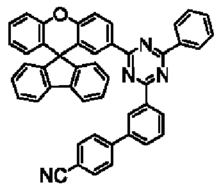 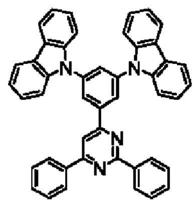

ET12 ET13 ET14 ET15

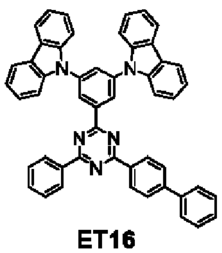 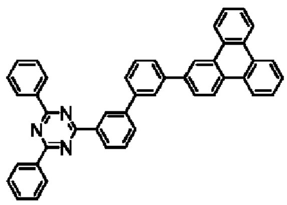 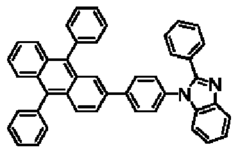 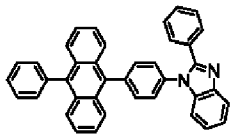

ET16 ET17 ET18 ET19

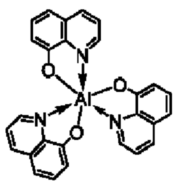 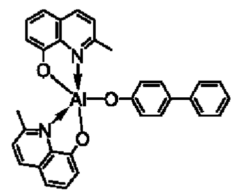 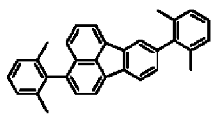 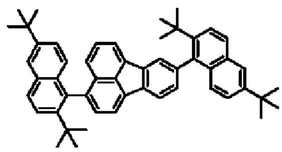

ET20 ET21 ET22 ET23

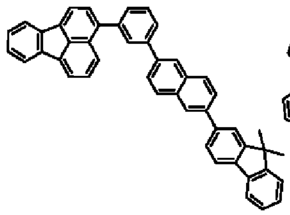 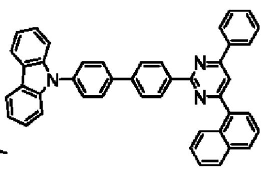 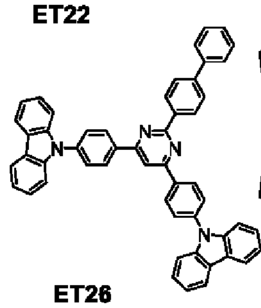 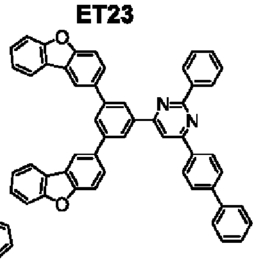

ET24 ET25 ET26 ET27

An electron injection material can be freely-selected from materials that can easily inject electrons from the cathode and is selected in consideration of, for example, the balance with the hole injection properties. As the organic compound, n-type dopants and reducing dopants are also included. Examples thereof include alkali metal-containing compounds, such as lithium fluoride, lithium complexes, such as lithium quinolinolate, benzimidazolidene derivatives, imidazolidene derivatives, fulvalene derivatives, and acridine derivatives.

Configuration of Organic Light-Emitting Device

The organic light-emitting device includes an insulating layer, a first electrode, an organic compound layer, a second electrode over a substrate. A protective layer, a color filter, a microlens, and so forth may be disposed over the cathode.

When the color filter is provided, a planarization layer may be provided between the color filter and the protective layer. The planarization layer can be composed of, for example, an acrylic resin. The same applies when a planarization layer is provided between the color filter and the microlens.

Substrate

Examples of the substrate include quartz, glass, silicon wafers, resins, and metals. The substrate may include a switching element, such as a transistor, a line, and an insulating layer thereon. Any material can be used for the insulating layer as long as a contact hole can be formed in such a manner that a line can be coupled to the first electrode and as long as insulation with a non-connected line can be ensured. For example, a resin, such as polyimide, silicon oxide, or silicon nitride, can be used. Electrode

A pair of electrodes can be used for the electrodes. The pair of electrodes may be an anode and a cathode.

When an electric field is applied in the direction in which the organic light-emitting device emits light, an electrode having a higher potential is the anode, and the other is the cathode. It can also be said that the electrode that supplies holes to the light-emitting layer is the anode and that the electrode that supplies electrons is the cathode.

As the component material of the anode, a material having a work function as high as possible can be used. Examples of the material that can be used include elemental metals, such as gold, platinum, silver, copper, nickel, palladium, cobalt, selenium, vanadium, and tungsten, mixtures thereof, alloys of combinations thereof, and metal oxides, such as tin oxide, zinc oxide, indium oxide, indium-tin oxide (ITO), and indium-zinc oxide. Additionally, conductive polymers, such as polyaniline, polypyrrole, and polythiophene, can be used.

These electrode materials may be used alone or in combination of two or more. The anode may be formed of a single layer or multiple layers.

When the anode is used as a reflective electrode, for example, chromium, aluminum, silver, titanium, tungsten, molybdenum, an alloy thereof, or a stack thereof can be used. These materials can also be used to act as a reflective film that does not have the role of an electrode. When the anode is used as a transparent electrode, a transparent conductive oxide layer composed of, for example, indium-tin oxide (ITO) or indium-zinc oxide can be used; however, the anode is not limited thereto.

The electrode can be formed by photolithography.

As the component material of the cathode, a material having a lower work function can be used. Examples thereof include elemental metals such as alkali metals e.g., lithium, alkaline-earth metals e.g., calcium, aluminum, titanium, manganese, silver, lead, and chromium, and mixtures thereof. Alloys of combinations of these elemental metals can also be used. For example, magnesium-silver, aluminum-lithium, aluminum-magnesium, silver-copper, and zinc-silver can be used. Metal oxides, such as indium-tin oxide (ITO), can also be used. These electrode materials may be used alone or in combination of two or more. The cathode may have a single-layer structure or a multilayer structure. In particular, silver can be used. To reduce the aggregation of silver, a silver alloy can be used. Any alloy ratio may be used as long as the aggregation of silver can be reduced. The ratio of silver to another metal may be, for example, 1:1 or 3:1.

A top emission device may be provided using the cathode formed of a conductive oxide layer composed of, for example, ITO. A bottom emission device may be provided using the cathode formed of a reflective electrode composed of, for example, aluminum (Al). Any type of cathode may be used. A method for forming the cathode is not particularly limited, but a direct-current sputtering method, an alternating-current sputtering method, or the like can be used because good film coverage is obtained and thus the resistance is easily reduced.

Pixel Separation Layer

The pixel separation layer is formed of a silicon nitride (SiN) film, a silicon oxynitride (SiON) film, or a silicon oxide (SiO) film formed by a chemical vapor deposition (CVD) method.

To increase the resistance in the in-plane direction of the organic compound layer, the organic compound layer, in particular, the hole transport layer, can be formed so as to have a small thickness at the side wall of the pixel separation layer. Specifically, the organic compound layer can be formed so as to have a small thickness at the side wall of the pixel separation layer by increasing the taper angle of the side wall of the pixel separation layer or the thickness of the pixel separation layer to increase vignetting at the time of vapor deposition.

The taper angle of the side wall of the pixel separation layer and the thickness of the pixel separation layer can be adjusted to such an extent that a void is not formed in the protective layer formed over the pixel separation layer.

Voids are not formed in the protective layer; thus, the occurrence of defects in the protective layer can be reduced. Since the occurrence of defects in the protective layer is reduced, it is possible to reduce reliability deterioration, such as the formation of dark spots and the occurrence of poor conduction of the second electrode.

According to the embodiment, even if the taper angle of the side wall of the pixel separation layer is not steep, it is possible to effectively inhibit charge leakage to an adjacent pixel. As a result of this study, it has been found that a sufficient reduction can be achieved when the taper angle is 60° or more and 90° or less. The pixel separation layer can have a thickness of 10 nm or more and 150 nm or less. The same effect can be provided even if the pixel electrode does not include the pixel separation layer. However, in this case, the thickness of the pixel electrode can be less than or equal to the half of the thickness of the organic layer, or the pixel electrode can have a forward tapered end portion of less than 60°, because the short circuit of the organic light-emitting device can be reduced.

Organic Compound Layer

The organic compound layer may be formed of a single layer or multiple layers. When multiple layers are present, they may be referred to as a hole injection layer, a hole transport layer, an electron-blocking layer, a light-emitting layer, a hole-blocking layer, an electron transport layer, or an electron injection layer in accordance with their functions. The organic compound layer is mainly composed of an organic compound, and may contain inorganic atoms and an inorganic compound. For example, the organic compound layer may contain, for example, copper, lithium, magnesium, aluminum, iridium, platinum, molybdenum, or zinc. The organic compound layer may be disposed between the first electrode and the second electrode, and may be disposed in contact with the first electrode and the second electrode.

When multiple light-emitting layers are disposed, a charge generation portion may be disposed between a first light-emitting layer and a second light-emitting layer. The charge generation portion may contain an organic compound having a LUMO energy level of -5.0 eV or less. The same applies to the case where a charge generation portion is disposed between the second light-emitting layer and a third light-emitting layer.

The charge generation portion is formed by forming an n/p junction with a p-type organic semiconductor layer and an n-type organic semiconductor layer, or by using a p-doped layer and an n-doped layer. For example, in the case of forming only a PIN junction, an electron injection layer can be disposed in order to further inject electrons extracted by the n-type organic semiconductor layer into the electron transport layer. Alternatively, a structure of n-doped layer/p-doped layer may be used. The configuration of the charge generation layer according to an embodiment of the present disclosure is not limited to the above.

In the p-doped layer, for example, high electron-withdrawing HAT-CN or a Lewis acid, such as molybdenum oxide, and an aromatic amine-based compound may be mixed. HAT-CN, molybdenum oxide, and so forth are n-type materials. These n-type materials may be used to form a stacked structure in which electrons are extracted from an adjacent layer to generate charges. An np junction composed of a p-doped layer or a stack of an n-type material and a p-type material is referred to as a p-charge generation layer.

For the n-doped layer, for example, a material having a low work function which is easily doped with electrons, such as an alkali metal or alkaline-earth metal, is used. The n-doped layer is referred to as an n-charge generation layer. Alternatively, LiF or the like may be combined with a thin film of a reducing metal to form an electron injection layer, and an n-type layer/p-type layer structure may be formed to generate charges.

Examples of an n-dopant that can be used include alkali metals, alkaline-earth metals, rare-earth metals, and compounds thereof, such as alkali metal compounds including oxides, such as lithium oxide, halides, and carbonates, such as lithium carbonate and cesium carbonate, alkaline-earth metal compounds including oxides, halides, and carbonates thereof, and rare-earth metal compounds including oxides, halides, and carbonates thereof. Organic compounds such as tetrathianaphthacene (abbreviated name: TTN), nickelocene, and decamethyl nickelocene, can also be used.

The organic light-emitting device according to an embodiment of the present disclosure may be used for a tandem device including a charge generation layer. In this case, carriers generated in the charge generation layer are injected from the first electrode or the second electrode.

In the case of a white light-emitting device, the device can be used as a light source for a display or lighting apparatus. In this case, since the organic light-emitting device according to an embodiment of the present disclosure has an improved lifetime, it is possible to provide a white light-emitting device having a long lifetime and only a small change in the luminance of light of an emission color.

Protective Layer

A protective layer may be disposed on the second electrode. For example, a glass member provided with a moisture absorbent can be bonded to the second electrode to reduce the entry of, for example, water into the organic compound layer, thereby reducing the occurrence of display defects. In another embodiment, a passivation film composed

of, for example, silicon nitride may be disposed on the cathode to reduce the entry of, for example, water into the organic compound layer. For example, after the formation of the cathode, the substrate may be transported to another chamber without breaking the vacuum, and a silicon nitride film having a thickness of 2 μm may be formed by a chemical vapor deposition (CVD) method to provide a protective layer. After the film deposition by the CVD method, a protective layer may be formed by an atomic layer deposition (ALD) method. Non-limiting examples of the material of the layer formed by the ALD method may include silicon nitride, silicon oxide, and aluminum oxide. Silicon nitride may be deposited by the CVD method on the layer formed by the ALD method. The film formed by the ALD method may have a smaller thickness than the film formed by the CVD method. Specifically, the thickness may be 50% or less, even 10% or less.

Color Filter

A color filter may be disposed on the protective layer. For example, a color filter may be disposed on another substrate in consideration of the size of the organic light-emitting device and bonded to the substrate provided with the organic light-emitting device. A color filter may be formed by patterning on the protective layer using photolithography. The color filter may be composed of a polymer.

Planarization Layer

A planarization layer may be disposed between the color filter and the protective layer. The planarization layer is provided for the purpose of reducing the unevenness of the layer underneath. Without limiting the purpose, the planarization layer may be referred to as a resin layer because of its material. The planarization layer may be composed of an organic compound. A low- or high-molecular-weight organic compound may be used. A high-molecular-weight organic compound can be used.

The planarization layers may be disposed above and below (or on) the color filter and may be composed of the same or different component materials. Specific examples thereof include poly(vinyl carbazole) resins, polycarbonate resins, polyester resins, acrylonitrile butadiene styrene (ABS) resins, acrylic resins, polyimide resins, phenolic resins, epoxy resins, silicone resins, and urea resins.

Microlens

The organic light-emitting apparatus may include an optical member, such as a microlens, on the outgoing light side. The microlens can be composed of, for example, an acrylic resin or an epoxy resin. The microlens may be used to increase the amount of light emitted from the organic light-emitting apparatus and to control the direction of the light emitted. The microlens may have a hemispherical shape. In the case of a hemispherical shape, among tangents to the hemisphere, there is a tangent parallel to the insulating layer. The point of contact of the tangent with the hemisphere is the vertex of the microlens. The vertex of the microlens can be determined in the same way for any cross-sectional view. That is, among the tangents to the semicircle of the microlens in the cross-sectional view, there is a tangent parallel to the insulating layer, and the point of contact of the tangent with the semicircle is the vertex of the microlens.

The midpoint of the microlens can be defined. In the cross section of the microlens, when a segment is hypothetically drawn from the point where an arc shape ends to the point where another arc shape ends, the midpoint of the segment can be referred to as the midpoint of the microlens. The cross section to determine the vertex and midpoint may be a cross section perpendicular to the insulating layer.

The microlens has a first surface having a convex portion and a second surface opposite to the first surface. The second surface can be disposed closer to the functional layer than the first surface. To form such a configuration, it is necessary to form a microlens on the light-emitting apparatus. When the functional layer is an organic layer, a high-temperature process can be avoided in the production process. When the second surface is closer to the functional layer than the first surface, the glass transition temperature of each organic compound constituting the organic layer is preferably 100°C or higher, more preferably 130°C or higher.

Opposite Substrate

An opposite substrate may be disposed on the planarization layer. The opposite substrate is disposed at a position corresponding to the substrate described above and thus is called an opposite substrate. The opposite substrate may be composed of the same material as the substrate described above. When the above-described substrate is referred to as a first substrate, the opposite substrate may be referred to as a second substrate.

## Organic Layer

The organic compound layer, such as the hole injection layer, the hole transport layer, the electron-blocking layer, the light-emitting layer, the hole-blocking layer, the electron transport layer, or the electron injection layer, included in the organic light-emitting device according to an embodiment of the present disclosure is formed by a method described below.

For the organic compound layer included in the organic light-emitting device according to an embodiment of the present disclosure, a dry process, such as a vacuum evaporation method, an ionized evaporation method, sputtering, or plasma, may be employed. Alternatively, instead of the dry process, it is also possible to employ a wet process in which a material is dissolved in an appropriate solvent and then a film is formed by a known coating method, such as spin coating, dipping, a casting method, a Langmuir-Blodgett (LB) technique, or an inkjet method.

When the layer is formed by, for example, the vacuum evaporation method or the solution coating method, crystallization and so forth are less likely to occur, and good stability with time is obtained. In the case of forming a film by the coating method, the film may be formed in combination with an appropriate binder resin.

Non-limiting examples of the binder resin include poly(vinyl carbazole) resins, polycarbonate resins, polyester resins, ABS resins, acrylic resins, polyimide resins, phenolic resins, epoxy resins, silicone resins, and urea resins.

These binder resins may be used alone as a homopolymer or copolymer or in combination as a mixture of two or more. Furthermore, additives, such as a known plasticizer, antioxidant, and ultraviolet absorber, may be used, as needed.

## Pixel Circuit

The light-emitting apparatus may include pixel circuits coupled to the light-emitting devices. Each of the pixel circuits may be of an active matrix type, which independently controls the emission of first and second light-emitting devices. The active matrix type circuit may be voltage programming or current programming. A driving circuit includes the pixel circuit for each pixel. The pixel circuit may include a light-emitting device, a transistor to control the luminance of the light-emitting device, a transistor to control the timing of the light emission, a capacitor to retain the gate voltage of the transistor to control the luminance, and a transistor to connect to GND without using the light-emitting device.

The light-emitting apparatus includes a display area and a peripheral area disposed around the display area. The display area includes a pixel circuit, and the peripheral area includes a display control circuit. The mobility of a transistor contained in the pixel circuit may be lower than the mobility of a transistor contained in the display control circuit.

The slope of the current-voltage characteristics of the transistor contained in the pixel circuit may be smaller than the slope of the current-voltage characteristic of the transistor contained in the display control circuit. The slope of the current-voltage characteristics can be measured by what is called Vg-Ig characteristics.

The transistor contained in the pixel circuit is a transistor coupled to a light-emitting device, such as a first light-emitting device.

## Pixel

The organic light-emitting apparatus includes multiple pixels. Each pixel includes subpixels configured to emit colors different from each other. The subpixels may have respective red, green, and blue (RGB) emission colors.

Light emerges from a region of the pixel, also called a pixel aperture. This region may also be referred to as a first region.

The pixel aperture may be 15 μm or less, and may be 5 μm or more. More specifically, the pixel aperture may be, for example, 11 μm, 9.5 μm, 7.4 μm, or 6.4 μm.

The distance between subpixels may be 10 μm or less. Specifically, the distance may be 8 μm, 7.4 μm, or 6.4 μm.

The pixels may be arranged in a known configuration in plan view. For example, a stripe pattern, a delta pattern, a Pen Tile matrix pattern, or the Bayer pattern may be used. The shape of each subpixel in plan view may be any known shape. Examples of the shape of the subpixel include quadrilaterals, such as rectangles and rhombi, and hexagons. Of course, if the shape is close to a rectangle, rather than an exact shape, it is included in the rectangle. The shape of the subpixel and the pixel arrangement can be used in combination.

## Application of Organic Light-Emitting Device According to Embodiment of the Present Disclosure

The organic light-emitting device according to an embodiment of the present disclosure can be used as a component member of a display apparatus or lighting apparatus. Other applications include exposure light sources for electrophotographic image-forming apparatuses, backlights for liquid crystal display apparatuses, and light-emitting apparatuses including white-light sources and color filters.

The display apparatus may be an image information-processing apparatus including an image input unit that receives image information from an area or linear CCD sensor, a memory card, or any other source, an information-processing unit that processes the input information, and a display unit that displays the input image.

The display unit of an image pickup apparatus or an inkjet printer may have a touch panel function. The driving mode of the touch panel function may be, but is not particularly limited to, an infrared mode, an electrostatic capacitance mode, a resistive film mode, or an electromagnetic inductive mode. The display apparatus may also be used for a display unit of a multifunction printer.

The following describes a display apparatus according to the present embodiment with reference to the attached drawings.

Figs. 1A and 1B are each a schematic cross-sectional view of an example of a display apparatus including organic light-emitting devices and transistors coupled to the respective organic light-emitting devices. Each of the transistors is an example of an active element. The transistors may be thin-film transistors (TFTs).

Fig. 1A is an example of pixels that are components of the display apparatus according to the present embodiment. Each of the pixels includes subpixels 10. The subpixels are divided into 10R, 10G, and 10B according to their light emission. The emission colors may be distinguished by the wavelength of light emitted from the light-emitting layer. Light emitted from the subpixels may be selectively transmitted or color-converted with, for example, a color filter. Each subpixel includes a reflective electrode 2 serving as a first electrode, an insulating layer 3 covering the edge of the reflective electrode 2, an organic compound layer 4 covering the first electrode and the insulating layer, a transparent electrode 5, a protective layer 6, and a color filter 7, over an interlayer insulating layer 1.

The transistors and capacitive elements may be disposed under or in the interlayer insulating layer 1.

Each transistor may be electrically coupled to a corresponding one of the first electrodes through a contact hole (not illustrated).

The insulating layer 3 is also called a bank or pixel separation film. The insulating layer covers the edge of each first electrode and surrounds the first electrode. Portions that are not covered with the insulating layer are in contact with the organic compound layer 4 and serve as light-emitting regions.

The organic compound layer 4 includes a hole injection layer 41, a hole transport layer 42, a first light-emitting layer 43, a second light-emitting layer 44, and an electron transport layer 45.

The second electrode 5 may be a transparent electrode, a reflective electrode, or a semi-transparent electrode.

The protective layer 6 reduces the penetration of moisture into the organic compound layer. Although the protective layer is illustrated as a single layer, the protective layer may include multiple layers, and each layer may be an inorganic compound layer or an organic compound layer.

The color filter 7 is separated into 7R, 7G, and 7B according to its color. The color filter may be disposed on a planarizing film (not illustrated). A resin protective layer (not illustrated) may be disposed on the color filter. The color filter may be disposed on the protective layer 6. Alternatively, the color filter may be disposed on an opposite substrate, such as a glass substrate, and then bonded.

A display apparatus 100 illustrated in Fig. 1B includes organic light-emitting devices 26 and TFTs 18 as an example of transistors. A substrate 11 composed of a material, such as glass or silicon, is provided, and an insulating layer 12 is disposed thereon. Active elements 18, such as the TFTs, are disposed on the insulating layer. The gate electrode 13, the gate insulating film 14, and the semiconductor layer 15 of each of the active elements are disposed thereon. Each TFT 18 further includes a semiconductor layer 15, a drain electrode 16, and a source electrode 17. The TFTs 18 are overlaid with an insulating film 19. Anode 21 included in the organic light-emitting devices 26 is coupled to the source electrodes 17 through contact holes 20 provided in the insulating film.

The mode of electrical connection between the electrodes (anode and cathode) included in each organic light-emitting device 26 and the electrodes (source electrode and drain electrode) included in a corresponding one of the TFTs is not limited to the mode illustrated in Fig. 1B. That is, it is sufficient that any one of the anode and the cathode is electrically coupled to any one of the source electrode and the drain electrode of the TFT. The term "TFT" refers to a thin-film transistor.

In the display apparatus 100 illustrated in Fig. 1B, although each organic compound layer 22 is illustrated as a single layer, the organic compound layer 22 may include multiple layers. To reduce the deterioration of the organic light-emitting devices, a first protective layer 24 and a second protective layer 25 are disposed on the cathodes 23.

In the display apparatus 100 illustrated in Fig. 1B, although the transistors are used as switching elements, other switching elements may be used instead.

The transistors used in the display apparatus 100 illustrated in Fig. 1B are not limited to transistors using a single-crystal silicon wafer, but may also be thin-film transistors including active layers on the insulating surface of a substrate. Examples of the material of the active layers include single-crystal silicon, non-single-crystal silicon, such as amorphous silicon and microcrystalline silicon; and non-single-crystal oxide semiconductors, such as indium zinc oxide and indium gallium zinc oxide. Thin-film transistors are also called TFT elements.

The transistors in the display apparatus 100 illustrated in Fig. 1B may be formed in the substrate, such as a Si

substrate. The expression "formed in the substrate" indicates that the transistors are produced by processing the substrate, such as a Si substrate. In the case where the transistors are formed in the substrate, the substrate and the transistors can be deemed to be integrally formed.

In the organic light-emitting device according to the present embodiment, the luminance is controlled by the TFT devices, which are an example of switching elements; thus, an image can be displayed at respective luminance levels by arranging multiple organic light-emitting devices in the plane. The switching devices according to the present embodiment are not limited to the TFT devices and may be low-temperature polysilicon transistors or active-matrix drivers formed on a substrate such as a Si substrate. The expression "on a substrate" can also be said to be "in the substrate". Whether transistors are formed in the substrate or TFT devices are used is selected in accordance with the size of a display unit. For example, in the case where the display unit has a size of about 0.5 inches, organic light-emitting devices can be disposed on a Si substrate.

Fig. 2 is a schematic view illustrating an example of a display apparatus according to the present embodiment. A display apparatus 1000 may include a touch panel 1003, a display panel 1005, a frame 1006, a circuit substrate 1007, and a battery 1008, disposed between an upper cover 1001 and a lower cover 1009. The touch panel 1003 and the display panel 1005 are coupled to flexible printed circuits FPCs 1002 and 1004, respectively. The circuit substrate 1007 includes printed transistors. The battery 1008 need not be provided unless the display apparatus is a portable apparatus. The battery 1008 may be disposed at a different position even if the display apparatus is a portable apparatus.

The display apparatus according to the present embodiment may include a color filter having red, green, and blue portions. In the color filter, the red, green, and blue portions may be arranged in a delta arrangement.

The display apparatus according to the present embodiment may be used for the display unit of a portable terminal. In that case, the display apparatus may have both a display function and an operation function. Examples of the portable terminal include mobile phones such as smartphones, tablets, and head-mounted displays.

The display apparatus according to the present embodiment may be used for a display unit of an image pickup apparatus including an optical unit including multiple lenses and an image pickup device that receives light passing through the optical unit. The image pickup apparatus may include a display unit that displays information acquired by the image pickup device. The display unit may be a display unit exposed to the outside of the image pickup apparatus or a display unit disposed in a finder. The image pickup apparatus may be a digital camera or a digital camcorder.

Fig. 3A is a schematic view illustrating an example of an image pickup apparatus according to the present embodiment. An image pickup apparatus 1100 may include a viewfinder 1101, a rear display 1102, an operation unit 1103, and a housing 1104. The viewfinder 1101 may include the display apparatus according to the present embodiment. In this case, the display apparatus may display environmental information, imaging instructions, and so forth in addition to an image to be captured. The environmental information may include, for example, the intensity of external light, the direction of external light, the moving speed of a subject, and the possibility that a subject is shielded by a shielding material.

The timing suitable for imaging is only for a short time. It is thus better to display the information as soon as possible. Accordingly, the display apparatus including the organic light-emitting device according to an embodiment of the present embodiment can be used. The display apparatus including the organic light-emitting device can be used more suitably than liquid crystal displays for such apparatuses required to have a high display speed.

The image pickup apparatus 1100 includes an optical unit (not illustrated). The optical unit includes multiple lenses and is configured to form an image on an image pickup device in the housing 1104. The relative positions of the multiple lenses can be adjusted to adjust the focal point. This operation can also be performed automatically. The image pickup apparatus may translate to a photoelectric conversion apparatus. Examples of an image capturing method employed in the photoelectric conversion apparatus may include a method for detecting a difference from the previous image and a method of cutting out an image from images always recorded, instead of sequentially capturing images.

Fig. 3B is a schematic view illustrating an example of an electronic apparatus according to the present embodiment. An electronic apparatus 1200 includes a display unit 1201, an operation unit 1202, and a housing 1203. The housing 1203 may accommodate a circuit, a printed circuit board including the circuit, a battery, and a communication unit. The operation unit 1202 may be a button or a touch-screen-type reactive unit. The operation unit may be a biometric recognition unit that recognizes a fingerprint to release the lock or the like. An electronic apparatus having a communication unit can also be referred to as a communication apparatus. The electronic apparatus may further have a camera function by being equipped with a lens and an image pickup device. An image captured by the camera function is displayed on the display unit. Examples of the electronic apparatus include smartphones and notebook computers.

Fig. 4A is a schematic view illustrating an example of the display apparatus according to the present embodiment. Fig. 4A illustrates a display apparatus, such as a television monitor or a PC monitor. A display apparatus 1300 includes a frame 1301 and a display unit 1302. The light-emitting apparatus according to the present embodiment may be used for the display unit 1302.

The display apparatus 1300 includes a base 1303 that supports the frame 1301 and the display unit 1302. The base 1303 is not limited to the structure illustrated in Fig. 4A. The lower side of the frame 1301 may also serve as a base.

The frame 1301 and the display unit 1302 may be curved. These may have a radius of curvature of 5,000 mm

or more and 6,000 mm or less.

Fig. 4B is a schematic view illustrating another example of a display apparatus according to the present embodiment. A display apparatus 1310 illustrated in Fig. 4B can be folded and is what is called a foldable display apparatus. The display apparatus 1310 includes a first display portion 1311, a second display portion 1312, a housing 1313, and an inflection point 1314. The first display portion 1311 and the second display portion 1312 may include the light-emitting apparatus according to the present embodiment. The first display portion 1311 and the second display portion 1312 may be a single, seamless display apparatus. The first display portion 1311 and the second display portion 1312 can be divided from each other at the inflection point. The first display portion 1311 and the second display portion 1312 may display different images. Alternatively, a single image may be displayed in the first and second display portions.

Fig. 5A is a schematic view illustrating an example of a lighting apparatus according to the present embodiment. A lighting apparatus 1400 may include a housing 1401, a light source 1402, a circuit board 1403, an optical film 1404, and a light diffusion unit 1405. The light source may include an organic light-emitting device according to the present embodiment. The optical film may be a film that improves the color rendering properties of the light source. The light diffusion unit can effectively diffuse light from the light source to deliver the light to a wide range when used for illumination and so forth. The optical film and the light diffusion unit may be disposed at the light emission side of the lighting apparatus. A cover may be disposed at the outermost portion, as needed.

The lighting apparatus is, for example, an apparatus that lights a room. The lighting apparatus may emit light of white, neutral white, or any color from blue to red. A light control circuit that controls the light may be provided.

The lighting apparatus may include the organic light-emitting device according to an embodiment of the present disclosure and a power supply circuit coupled thereto. The power supply circuit is a circuit that converts an AC voltage into a DC voltage. The color temperature of white is 4,200 K, and the color temperature of neutral white is 5,000 K. The lighting apparatus may include a color filter.

The lighting apparatus according to the present embodiment may include a heat dissipation unit. The heat dissipation unit is configured to release heat in the device to the outside of the device and is composed of, for example, a metal having a high specific heat and liquid silicone.

Fig. 5B is a schematic view illustrating an automobile as an example of a moving object according to the present embodiment. The automobile includes a tail lamp, which is an example of lighting units. An automobile 1500 includes a tail lamp 1501 and may be configured to light the tail lamp when a brake operation or the like is performed.

The tail lamp 1501 may include an organic light-emitting device according to the present embodiment. The tail lamp may include a protective member that protects the organic light-emitting device. The protective member may be composed of any transparent material having high strength to some extent and can be composed of, for example, polycarbonate. The polycarbonate may be mixed with, for example, a furandicarboxylic acid derivative or an acrylonitrile derivative.

The automobile 1500 may include an automobile body 1503 and windows 1502 attached thereto. The windows may be transparent displays if the windows are not used to check the front and back of the automobile. The transparent displays may include an organic light-emitting device according to the present embodiment. In this case, the components, such as the electrodes, of the organic light-emitting device are formed of transparent members.

The moving object according to the present embodiment may be, for example, a ship, an aircraft, or a drone. The moving object may include a body and a lighting unit attached to the body. The lighting unit may emit light to indicate the position of the body. The lighting unit includes the organic light-emitting device according to the present embodiment.

Examples of applications of the display apparatuses of the above embodiments will be described with reference to Figs. 6A and 6B. The display apparatuses can be used for systems that can be worn as wearable devices, such as smart glasses, head-mounted displays (HMDs), and smart contacts. An image pickup and display apparatus used in such an example of the applications has an image pickup apparatus that can photoelectrically convert visible light and a display apparatus that can emit visible light.

Fig. 6A illustrates glasses 1600 (smart glasses) according to an example of applications. An image pickup apparatus 1602, such as a complementary metal-oxide semiconductor (CMOS) sensor or a single-photon avalanche diode (SPAD), is provided on a front side of a lens 1601 of the glasses 1600. The display apparatus according to any of the above-mentioned embodiments is provided on the back side of the lens 1601.

The glasses 1600 further include a control unit 1603. The control unit 1603 functions as a power source that supplies electric power to the image pickup apparatus 1602 and the display apparatus according to any of the embodiments. The control unit 1603 controls the operation of the image pickup apparatus 1602 and the display apparatus. The lens 1601 has an optical system for focusing light on the image pickup apparatus 1602.

Fig. 6B illustrates glasses 1610 (smart glasses) according to an example of applications. The glasses 1610 include a control unit 1612. The control unit 1612 includes an image pickup apparatus corresponding to the image pickup apparatus 1602 and a display apparatus. A lens 1611 includes an optical system configured to project light emitted from the display apparatus in the control unit 1612. An image is projected onto the lens 1611. The control unit 1612 functions as a power source that supplies electric power to the image pickup apparatus and the display apparatus and controls

the operation of the image pickup apparatus and the display apparatus. The control unit may include a gaze detection unit that detects the gaze of a wearer. Infrared light may be used for gaze detection.

An infrared light-emitting unit emits infrared light to an eyeball of a user who is gazing at a displayed image. An image of the eyeball is captured by detecting the reflected infrared light from the eyeball with an image pickup unit having light-receiving elements. The deterioration of image quality is reduced by providing a reduction unit configured to reduce light from the infrared light-emitting unit to the display unit when viewed in plan.

The user's gaze at the displayed image is detected from the image of the eyeball captured with the infrared light. Any known method can be used to the gaze detection using the captured image of the eyeball. As an example, a gaze detection method based on a Purkinje image of the reflection of irradiation light on a cornea can be used.

More specifically, the gaze detection process is based on a pupil-corneal reflection method. Using the pupil-corneal reflection method, the user's gaze is detected by calculating a gaze vector representing the direction (rotation angle) of the eyeball based on the image of the pupil and the Purkinje image contained in the captured image of the eyeball.

A display apparatus according to an embodiment of the present disclosure may include an image pickup apparatus including light-receiving elements, and may control an image displayed on the display apparatus based on the gaze information of the user from the image pickup apparatus.

Specifically, in the display apparatus, a first display area at which the user gazes and a second display area other than the first display area are determined on the basis of the gaze information. The first display area and the second display area may be determined by the control unit of the display apparatus or may be determined by receiving those determined by an external control unit. In the display area of the display apparatus, the display resolution of the first display area may be controlled to be higher than the display resolution of the second display area. That is, the resolution of the second display area may be lower than that of the first display area.

The display area includes a first field-of-view area and a second field-of-view area different from the first field-of-view area. Based on the gaze information, an area of higher priority is determined from the first field-of-view and the second field-of-view area. The first field-of-view area and the second field-of-view area may be determined by the control unit of the display apparatus or may be determined by receiving those determined by an external control unit. The resolution of an area of higher priority may be controlled to be higher than the resolution of an area other than the area of higher priority. In other words, the resolution of an area of a relatively low priority may be low.

Artificial intelligence (AI) may be used to determine the first display area or the high-priority area. The AI may be a model configured to estimate the angle of gaze from the image of the eyeball and the distance to a target object located in the gaze direction, using the image of the eyeball and the actual direction of gaze of the eyeball in the image as teaching data. The AI program may be stored in the display apparatus, the image pickup apparatus, or an external apparatus. When the AI program is stored in the external apparatus, the AI program is transmitted to the display apparatus via communications.

In the case of controlling the display based on visual detection, smart glasses that further include an image pickup apparatus that captures an external image can be used. The smart glasses can display the captured external information in real time.

Figs. 7A, 7B, and 7C illustrate an image-forming apparatus according to an embodiment of the present disclosure. Fig. 7A is a schematic view of an image-forming apparatus 36 according to an embodiment of the present disclosure. The image-forming apparatus includes a photoconductor, an exposure light source, a developing unit, a charging unit, a transfer unit, a transport roller, and a fusing unit.

The irradiation of light 29 is performed from the exposure light source 28 to form an electrostatic latent image on the surface of the photoconductor 27. This exposure light source includes an organic light-emitting device according to an embodiment of the present disclosure. The developing unit 31 contains, for example, a toner. The charging unit 30 charges the photoconductor. The transfer unit 32 transfers the developed image to a recording medium 34. The transport roller 33 transports the recording medium 34. The recording medium 34 is paper, for example. The fusing unit 35 fixes the image formed on the recording medium.

Figs. 7B and 7C are each a schematic view illustrating a state in which multiple light-emitting portions 38 are arranged on a long substrate in the exposure light source 28. Arrows 37 are parallel to the axis of the photoconductor and each represent the row direction in which the organic light-emitting devices are arranged. The row direction is the same as the direction of the axis on which the photoconductor 27 rotates. This direction can also be referred to as the long-axis direction of the photoconductor.

Fig. 7B illustrates a configuration in which the light-emitting portions are arranged in the long-axis direction of the photoconductor. Fig. 7C is different from Fig. 7B in that the light-emitting portions are arranged alternately in the row direction in a first row and a second row. The first row and the second row are located at different positions in the column direction.

In the first row, the multiple light-emitting portions are spaced apart. The second row has the light-emitting portions at positions corresponding to the positions between the light-emitting portions in the first row. In other words, the multiple light-emitting portions are also spaced apart in the column direction.

The arrangement in Fig. 7C can be rephrased as, for example, a lattice arrangement, a staggered arrangement, or a checkered pattern.

As described above, the use of an apparatus including the organic light-emitting device according to the present embodiment enables a stable display with good image quality even for a long time.

EXAMPLES

Although examples are described below, the contents of the present disclosure are not limited to the following contents.

Charge-Trapping Properties of Light-Emitting Layer

The charge-trapping properties generated from the difference between the HOMO and LUMO levels of the host material of the light-emitting layer and the HOMO and LUMO levels of the light-emitting dopant added contribute to the luminous efficiency due to trap recombination in the light-emitting layer. Combinations of HOMO and LUMO of the light-emitting layer used in these examples of the present disclosure are presented below. Note that each HOMO level is a value determined by ionization potential measurement, and each LUMO level is a value obtained by subtracting a band gap determined from the absorption spectrum of a single film of each material.

Table 2

| Configuration of light-emitting layer | | HOMO | LUMO | ΔHOMO | ΔLUMO | Type of charge trapped |
|---|---|---|---|---|---|---|
| Electron trap-type blue light-emitting layer | EM2 | -5.97 | -2.92 | | | |
| | BD7 | -6.01 | -3.25 | -0.04 | -0.33 | Electron |
| Electron trap-type yellow light-emitting layer | EM2 | -5.97 | -2.92 | | | |
| | GD6 | -5.87 | -3.49 | 0.1 | -0.57 | Electron |
| | RD1 | -5.62 | -3.82 | 0.35 | -0.9 | Electron |
| Hole trap-type blue light emitting layer | EM2 | -5.97 | -2.92 | | | |
| | BD3 | -5.59 | -2.72 | 0.38 | 0.2 | Hole |

The following examples will be described using the light-emitting layer having the above combination. Although cesium carbonate, which has a strong n-doping ability, is used as the n-dopant in the Examples, other vapor-depositable n-dopants can be used in the same manner, and the n-dopant is not limited to cesium carbonate.

Example 1

In this example, a top emission-type stacked organic light-emitting device was produced in which an anode, a light-emitting unit 1, a charge generation portion, a light-emitting unit 2, and a cathode were sequentially formed over a substrate. A blue light-emitting layer was used for the light-emitting unit 1. A light-emitting layer containing a green light-emitting dopant and a red light-emitting dopant was used for the light-emitting unit 2. The organic light-emitting device produced had a double-sided light-emitting structure.

An ITO film was formed on a glass substrate and subjected to desired patterning to form an ITO electrode (anode). The ITO electrode had a thickness of 100 nm. The substrate on which the ITO electrode had been formed in this way was used as an ITO substrate in the following steps. Next, the light-emitting unit 1, the charge generation portion, and the light-emitting unit 2 given in Table 3 below were formed in this order by vacuum vapor deposition using resistance heating in a vacuum chamber. Here, the opposing electrode (metal electrode layer, cathode) had an electrode area of 3 mm$^2$. After forming the films up to the cathode, the substrate was transferred to a glove box and sealed with a glass cap containing a drying agent in a nitrogen atmosphere to provide an organic light-emitting device.

Table 3

| Unit | Name of organic layer | Material | | Film thickness (nm) |
|---|---|---|---|---|
| Cathode | Cathode | Mg | Ratio by weight Mg:Ag = 50: 50 | 10 |
| | | Ag | | |
| | Electron injection layer 2 | LiF | | 1 |
| Light-emitting unit 2 | Electron transport layer 2 | ET2 | | 20 |
| | Hole-blocking layer 2 | ET12 | | 26 |
| | Second light-emitting layer | EM1 | Ratio by weight EM1:GD6: RD1 = 97.6:2:0.4 | 20 |
| | | GD6 | | |
| | | RD1 | | |
| | Electron-blocking layer 2 | HT7 | | 10 |
| Charge generation region | Hole transport layer 2 | HT2 | | 25 |
| | Hole injection layer 2 | HT16 | | 8 |
| | Electron injection layer 1 [n-charge generation layer] | ET2 | Ratio by weight ET2:$Cs_2CO_3$ = 99:1 | 10 |
| | | $Cs_2CO_3$ | | |
| Light-emitting unit 1 | Electron transport layer 1 | ET2 | Ratio by weight ET2:ETM2-1 = 70:30 | 20 |
| | | ETM2-1 | | |
| | Hole-blocking layer 1 | ET12 | | 33 |
| | First light-emitting layer | EM1 | Ratio by weight EM1:BD8 = 99:1 | 20 |
| | | BD7 | | |
| | | | | |
| | Electron-blocking layer 1 | HT7 | | 10 |
| | Hole transport layer 1 | HT2 | | 25 |
| | Hole injection layer 1 | HT16 | | 7 |

Comparative Example 1

As a comparative example, a device in which the electron transport layer 1 was composed only of ET2 was produced.

Table 4

| Unit | Name of organic layer | Material | | Film thickness (nm) |
|---|---|---|---|---|
| Cathode | Cathode | Mg | Ratio by weight Mg:Ag = 50: 50 | 10 |
| | | Ag | | |
| | Electron injection layer 2 | LiF | | 1 |

(continued)

| Unit | Name of organic layer | Material | | Film thickness (nm) |
|---|---|---|---|---|
| Light-emitting unit 2 | Electron transport layer 2 | ET2 | | 20 |
| | Hole-blocking layer 2 | ET12 | | 26 |
| | Second light-emitting layer | EM1 | Ratio by weight EM1:GD6: RD1 = 97.6:2:0.4 | 20 |
| | | GD6 | | |
| | | RD1 | | |
| | Electron-blocking layer 2 | HT7 | | 10 |
| Charge generation region | Hole transport layer 2 | HT2 | | 25 |
| | Hole injection layer 2 | HT16 | | 8 |
| | Electron injection layer 1 [n-charge generation layer] | ET2 | Ratio by weight ET2:$Cs_2CO_3$ = 99:1 | 10 |
| | | $Cs_2CO_3$ | | |
| Light-emitting unit 1 | Electron transport layer 1 | ET2 | | 20 |
| | Hole-blocking layer 1 | ET12 | | 33 |
| | First light-emitting layer | EM1 | Ratio by weight EM1:BD8 = 99:1 | 20 |
| | | BD7 | | |
| | | | | |
| | Electron-blocking layer 1 | HT7 | | 10 |
| | Hole transport layer 1 | HT2 | | 25 |
| | Hole injection layer 1 | HT16 | | 7 |

The voltage-current characteristics were measured with a Hewlett-Packard 4140B microammeter. The emission spectrum was obtained with a Topcon "SR-3". As presented in Fig. 8, the organic light-emitting device of Example 1 and the organic light-emitting device of Comparative Example 1 exhibited similar white EL emission spectra.

Next, a drive test was performed on both devices under a constant current condition of 50 mA/$cm^2$. LT80, which is the time required for the luminance to deteriorate by 20% from the initial luminance, was evaluated from the durability curve illustrated in Fig. 9. Below is a summary of the LT80 times estimated from the above.

Table 5

| | LT80 [hr] @50mA/$cm^2$ |
|---|---|
| Example 1 | 540 |
| Comparative Example 1 | 271 |

As in Example 1, the second electron transport material inhibited a deterioration in the electron injection properties of the n-charge generation layer due to energization, thereby improving the durability. The results of the driving test for LT80 indicated 271 hours for Comparative Example 1 and 540 hours for Example 1. Examples 2 to 5

This is a result of satisfying requirements 1 and 2 in an embodiment of the present disclosure. Tandem organic light-emitting devices were produced in the same manner as in Example 1, except that ETM2-1 in the electron transport layer 1 was changed to the following second electron transport materials, and the evaluation results for LT80 are illustrated in the following table.

Table 6

| Example | Second electron transport material | μ (electron) $cm^2/Vs$ [@$700V^{1/2}cm^{1/2}$] | LUMO | \|ΔLUMO\| | LT80 [hr] @$50mA/cm^2$ |
|---|---|---|---|---|---|
| Example 1 | ETM2-1 | $1.5\times10^{-3}$ | -3.1 | 0.03 | 540 |
| Example 2 | ETM2-18 | $3.2\times10^{-3}$ | -3.1 | 0.01 | 650 |
| Example 3 | ETM2-19 | $2.2\times10^{-3}$ | -3.1 | 0.02 | 600 |
| Example 4 | ETM2-20 | $1.0\times10^{-4}$ | -2.7 | 0.36 | 380 |
| Example 5 | ETM2-21 | $3.0\times10^{-4}$ | -2.7 | 0.33 | 350 |

The above-described mobility was determined as follows: Each material was deposited on an ITO substrate to a thickness of about 3 μm by vacuum vapor deposition. An Al electrode was vacuum-deposited to form an upper electrode, thereby producing the device. The mobility was determined from a transient response signal of a photocurrent pulse generated by irradiating the device with a nitrogen laser. The LUMO level is a value obtained by measuring the ionization potential with AC-3 available from Riken Keiki Co., Ltd. and subtracting the band gap determined from the optical absorption edge. The LUMO difference is the absolute value of the difference between the LUMO level of ET2 of the first electron transport material and -3.07 eV. It was found that the operating lifetime tended to be longer as the mobility was higher and the LUMO difference was smaller.

Examples 6 to 20

Hereinafter, focusing on the LUMO difference, devices were prototyped as in Example 1, except that ETM2-1 of each electron transport layer 1 was changed, and LT80 was evaluated.

Table 7

| Example | Second electron transport material | LUMO | \|ΔLUMO\| | LT80 [hr] @$50mA/cm^2$ |
|---|---|---|---|---|
| Example 6 | ETM2-2 | -2.94 | 0.13 | 460 |
| Example 7 | ETM2-3 | -2.97 | 0.10 | 500 |
| Example 8 | ETM2-4 | -3.04 | 0.03 | 550 |
| Example 9 | ETM2-5 | -3.05 | 0.02 | 600 |
| Example 10 | ETM2-6 | -3.07 | 0.00 | 650 |
| Example 11 | ETM2-7 | -2.91 | 0.16 | 405 |
| Example 12 | ETM2-8 | -3.06 | 0.01 | 650 |
| Example 13 | ETM2-9 | -3.05 | 0.02 | 600 |
| Example 14 | ETM2-10 | -3.15 | 0.08 | 490 |
| Example 15 | ETM2-11 | -3.13 | 0.06 | 550 |
| Example 16 | ETM2-12 | -3.06 | 0.01 | 540 |
| Example 17 | ETM2-13 | -3.16 | 0.09 | 550 |
| Example 18 | ETM2-14 | -2.81 | 0.26 | 350 |
| Example 19 | ETM2-16 | -3.01 | 0.06 | 475 |
| Example 20 | ETM2-17 | -3.03 | 0.04 | 550 |

The small LUMO difference resulted in the inhibition of a decrease in mobility due to electron trapping, thereby improving LT80.

Examples 21 to 26

A device configuration of the organic light-emitting device according to an embodiment of the present disclosure includes a configuration in which the electron injection layer 1 (n-type charge generation layer) contains a fourth electron transport material, as described below. As Example 21, a tandem organic light-emitting device containing ETM2-1 in the electron transport layer 1 and the electron injection layer 1 as presented in Table 8 was produced, and LT80 was evaluated.

Table 8

| Unit | Name of organic layer | Material | | Film thickness (nm) |
|---|---|---|---|---|
| Cathode | Cathode | Mg | Ratio by weight Mg:Ag = 50:50 | 10 |
| | | Ag | | |
| | Electron injection layer 2 | LiF | | 1 |
| Light-emitting unit 2 | Electron transport layer 2 | ET2 | | 20 |
| | Hole-blocking layer 2 | ET12 | | 26 |
| | Second light-emitting layer | EM1 | Ratio by weight EM1:GD6: RD1 = 97.6:2:0.4 | 20 |
| | | GD6 | | |
| | | RD1 | | |
| | Electron-blocking layer 2 | HT7 | | 10 |
| Charge generation region | Hole transport layer 2 | HT2 | | 25 |
| | Hole injection layer 2 | HT16 | | 8 |
| | Electron injection layer 1 [n-charge generation layer] | ET2 | Ratio by weight ET2:ETM1: $Cs_2CO_3$ = 69.3:29.7:1 | 10 |
| | | ETM2-1 | | |
| | | $Cs_2CO_3$ | | |
| Light-emitting unit 1 | Electron transport layer 1 | ET2 | Ratio by weight ET2:ETM2-1 = 70:30 | 20 |
| | | ETM2-1 | | |
| | Hole-blocking layer 1 | ET12 | | 33 |
| | First light-emitting layer | EM1 | Ratio by weight EM1:BD8 = 99:1 | 20 |
| | | BD7 | | |
| | | | | |
| | Electron-blocking layer 1 | HT7 | | 10 |
| | Hole transport layer 1 | HT2 | | 25 |
| | Hole injection layer 1 | HT16 | | 7 |

Tandem organic light-emitting devices were produced in the same manner, except that the following combinations were used instead of ETM2-1, and the LT80 was examined.

Table 9

| Example | Second electron transport material | Fourth electron transport material | LT80 [hr] @50mA/$cm^2$ |
|---|---|---|---|
| Example 21 | ETM2-1 | ETM2-1 | 850 |
| Example 22 | ETM2-2 | ETM2-4 | 700 |
| Example 23 | ETM2-16 | ETM2-10 | 750 |

(continued)

| Example | Second electron transport material | Fourth electron transport material | LT80 [hr] @50mA/cm$^2$ |
|---|---|---|---|
| Example 24 | ETM2-19 | ETM2-7 | 800 |
| Example 25 | ETM2-2 | ETM2-2 | 830 |
| Example 26 | ETM2-18 | ETM2-18 | 840 |

In the above combinations, the same concentration ratio is used, but the effect of the present disclosure is not limited to this concentration ratio.

Examples 27 to 32

Tandem organic light-emitting devices having the same device configuration as in Example 1 were produced, except that the concentration of the second electron transport material was changed, and LT80 was evaluated.

Table 10

| Example | Second electron transport material | Concentration (wt%) | LT80 [hr] @50mA/cm$^2$ |
|---|---|---|---|
| Example 27 | ETM2-3 | 10 | 390 |
| Example 3 | ETM2-3 | 30 | 500 |
| Example 28 | ETM2-3 | 50 | 440 |
| Example 29 | ETM2-18 | 10 | 420 |
| Example 2 | ETM2-18 | 30 | 650 |
| Example 30 | ETM2-18 | 50 | 480 |
| Example 31 | ETM2-20 | 10 | 320 |
| Example 4 | ETM2-20 | 30 | 380 |
| Example 32 | ETM2-20 | 50 | 360 |

It was found that the durability improvement effect was high from 10% by weight to 50% by weight, and was particularly high at 30% by weight.

Examples 33 to 37

A tandem organic light-emitting device presented in Table 11 below was produced in the same manner as in Example 1, except that the light-emitting layers of the first light-emitting layer and the second light-emitting layer were changed, and ETM2-1 was used as the second electron transport material.

Table 11

| Unit | Name of organic layer | Material | | Film thickness (nm) |
|---|---|---|---|---|
| Cathode | Cathode | Mg | Ratio by weight Mg:Ag = 50: 50 | 10 |
| | | Ag | | |
| | Electron injection layer 2 | LiF | | 1 |

(continued)

| Unit | Name of organic layer | Material | | Film thickness (nm) |
|---|---|---|---|---|
| Light-emitting unit 2 | Electron transport layer 2 | ET2 | | 20 |
| | Hole-blocking layer 2 | ET12 | | 26 |
| | Second light-emitting layer | EM1<br>BD8 | Ratio by weight EM1:BD8 = 99:1 | 20 |
| | Electron-blocking layer 2 | HT7 | | 10 |
| Charge generation region | Hole transport layer 2 | HT2 | | 25 |
| | Hole injection layer 2 | HT16 | | 8 |
| | Electron injection layer 1 [n-charge generation layer] | ET2<br>$Cs_2CO_3$ | Ratio by weight ET2:$Cs_2CO_3$ = 99:1 | 10 |
| Light-emitting unit 1 | Electron transport layer 1 | ET2<br>ETM2-1 | Ratio by weight ET2:ETM2-1 = 70:30 | 20 |
| | Hole-blocking layer 1 | ET12 | | 33 |
| | First light-emitting layer | EM1<br>GD6<br>RD1 | Ratio by weight EM1:GD6: RD1 = 97.6:2:0.4 | 20 |
| | Electron-blocking layer 1 | HT7 | | 10 |
| | Hole transport layer 1 | HT2 | | 25 |
| | Hole injection layer 1 | HT16 | | 7 |

The results were as follows.

Table 12

| Example | Second electron transport material | μ (electron) $cm^2/Vs$ [@$700V^{1/2}cm^{1/2}$] | LUMO | \|ΔLUMO\| | LT80 [hr] @$50mA/cm^2$ |
|---|---|---|---|---|---|
| Example 33 | ETM2-1 | $1.5\times10^{-3}$ | -3.10 | 0.03 | 520 |
| Example 34 | ETM2-18 | $3.2\times10^{-3}$ | -3.08 | 0.01 | 600 |
| Example 35 | ETM2-19 | $2.2\times10^{-3}$ | -3.09 | 0.02 | 590 |
| Example 36 | ETM2-20 | $1.0\times10^{-4}$ | -2.71 | 0.36 | 350 |
| Example 37 | ETM2-21 | $3.0\times10^{-4}$ | -2.74 | 0.33 | 430 |

Comparative Example 2

A device was prototyped as in Example 33, except that the electron transport layer 1 was composed only of ET2, similarly to Comparative Example 1.

Table 13

| Comparative Example | Second electron transport material | LT80 [hr] @$50mA/cm^2$ |
|---|---|---|
| Comparative Example 2 | No | 320 |

As in Examples 33 to 37, even in the device in which the yellow light-emitting layer composed of the red and green light-emitting materials was used as the first light-emitting layer, LT80 was improved.

Example 38

A device was prototyped as in Example 1, except that BD3 containing an aromatic amine skeleton and having electron transport properties was used as the blue light-emitting material of the first light-emitting layer.

Table 14

| Unit | Name of organic layer | Material | | Film thickness (nm) |
|---|---|---|---|---|
| Cathode | Cathode | Mg | Ratio by weight Mg:Ag = 50:50 | 10 |
| | | Ag | | |
| | Electron injection layer 2 | LiF | | 1 |
| Light-emitting unit 2 | Electron transport layer 2 | ET2 | | 20 |
| | Hole-blocking layer 2 | ET12 | | 26 |
| | Second light-emitting layer | EM1 | Ratio by weight EM1:GD6: RD1 = 97.6:2:0.4 | 20 |
| | | GD6 | | |
| | | RD1 | | |
| | Electron-blocking layer 2 | HT7 | | 10 |
| Charge generation region | Hole transport layer 2 | HT2 | | 25 |
| | Hole injection layer 2 | HT16 | | 8 |
| | Electron injection layer 1 [n-charge generation layer] | ET2 | Ratio by weight ET2:$Cs_2CO_3$ = 99:1 | 10 |
| | | $Cs_2CO_3$ | | |
| Light-emitting unit 1 | Electron transport layer 1 | ET2 | Ratio by weight ET2:ETM2-1 = 70:30 | 20 |
| | | ETM2-1 | | |
| | Hole-blocking layer 1 | ET12 | | 33 |
| | First light-emitting layer | EM1 | Ratio by weight EM1:BD3 = 99:1 | 20 |
| | | BD3 | | |
| | | | | |
| | Electron-blocking layer 1 | HT7 | | 10 |
| | Hole transport layer 1 | HT2 | | 25 |
| | Hole injection layer 1 | HT16 | | 7 |

Comparative Example 3

A device was produced as in Example 38, except that the electron transport layer 1 was composed only of ET2.

In Comparative Examples 1 and 3, the blue light-emitting material was changed from an electron-trap type to a hole-trap type. In the hole-trap type, the bond between carbon and nitrogen is weak; thus, the durability characteristics are slightly deteriorated. The improvement of LT80 is observed in Example 38 as compared to Comparative Example 3, indicating that it is also effective in the hole trap-type light-emitting layer. The organic light-emitting device according to an embodiment of the present disclosure also has the effect of reducing deterioration due to holes leaked from the light-emitting layer. When the light-emitting layer is of a hole-trap type, hole leakage from the light-emitting layer is inhibited in the first place. Thus, the effect of improving LT80 is small as compared with an electron-trap type light-emitting layer.

Table 15

| | LT80 [hr] @50mA/cm$^2$ |
|---|---|
| Example 38 | 270 |
| Comparative Example 3 | 160 |

Comparative Examples 4 to 7

Tandem organic light-emitting devices were produced in the same manner as in Examples 1 and 38, except that an electron transport material having phenanthroline as a polar skeleton, such as ET1 or ET4, was used as the second electron transport material, and LT80 was evaluated.

Table 16

| | Second electron transport material | LT80 [hr] @50mA/cm$^2$ |
|---|---|---|
| Comparative Example 1 | No | 271 |
| Comparative Example 3 | No | 160 |
| Comparative Example 4 | ET1 | 270 |
| Comparative Example 5 | ET4 | 271 |
| Comparative Example 6 | ET1 | 158 |
| Comparative Example 7 | ET4 | 160 |

In Comparative Examples 4 and 5, LT80 was not changed as compared with Comparative Example 1. Similarly, there was no change in LT80 between Comparative Examples 6 and 7 as compared with Comparative Example 3. Even when the electron transport material having a polar skeleton was mixed as the second electron transport material, LT80 was not improved.

Examples 39 to 43

A device having the same device configuration as in Comparative Example 1 was produced, except that the electron transport layer 1 was formed of a single film composed of ETM2-1. Similarly, a device in which ETM2-1 was replaced with another compound was also produced. The evaluation results for LT80 are presented below.

Table 17

| Example | Electron transport layer 1 | $\mu$ (electron) cm$^2$/Vs [@700V$^{1/2}$cm$^{1/2}$] | LUMO | LT80 [hr] @50mA/cm$^2$ |
|---|---|---|---|---|
| Example 39 | ETM2-1 | $1.5\times10^{-3}$ | -3.1 | 490 |
| Example 40 | ETM2-18 | $3.2\times10^{-3}$ | -3.1 | 530 |
| Example 41 | ETM2-19 | $2.2\times10^{-3}$ | -3.1 | 500 |
| Example 42 | ETM2-20 | $1.0\times10^{-4}$ | -2.7 | 400 |
| Example 43 | ETM2-21 | $3.0\times10^{-4}$ | -2.7 | 430 |

Also in the above, LT80 is improved as compared with Comparative Example 1. However, the voltage was higher than that in Example 1 by 0.5 V or more at 50 mA/cm$^2$.

Examples 44 to 46

Devices having the same device configuration as in Example 1 were produced, except that an electron transport layer 1-2 having a thickness of 10 nm was newly provided between the electron transport layer 1 and the n-charge generation layer, and LT80 was evaluated.

Table 18

| Example | Second electron transport material | Electron transport layer 1-2 | LT80 [hr] @50mA/$cm^2$ |
|---|---|---|---|
| Example 44 | ETM2-16 | ET2 | 550 |
| Example 45 | ETM2-16 | ETM2-16 | 570 |
| Example 46 | ETM2-16 | ET5 | 550 |

LT80 was improved also in the above configuration, compared with Comparative Example 1.

Example 47

A tandem organic light-emitting device was produced in the same manner as in Example 1, except that Li was used as the n-dopant, and LT80 was evaluated. That is, the layer structure is as presented in Table 19 below.

Table 19

| Unit | Name of organic layer | Material | | Film thickness (nm) |
|---|---|---|---|---|
| Cathode | Cathode | Mg | Ratio by weight Mg:Ag = 50: 50 | 10 |
| | | Ag | | |
| | Electron injection layer 2 | LiF | | 1 |
| Light-emitting unit 2 | Electron transport layer 2 | ET2 | | 20 |
| | Hole-blocking layer 2 | ET12 | | 26 |
| | Second light-emitting layer | EM1 | Ratio by weight EM1:GD6: RD1 = 97.6:2:0.4 | 20 |
| | | GD6 | | |
| | | RD1 | | |
| | Electron-blocking layer 2 | HT7 | | 10 |
| Charge generation region | Hole transport layer 2 | HT2 | | 25 |
| | Hole injection layer 2 | HT16 | | 8 |
| | Electron injection layer 1 [n-charge generation layer] | ET2 | Ratio by weight ET2:Li = 99: 1 | 10 |
| | | Li | | |
| Light-emitting unit 1 | Electron transport layer 1 | ET2 | Ratio by weight ET2: ETM2-1 = 70:30 | 20 |
| | | ETM2-1 | | |
| | Hole-blocking layer 1 | ET12 | | 33 |
| | First light-emitting layer | EM1 | Ratio by weight EM1:BD8 = 99:1 | 20 |
| | | BD7 | | |
| | | | | |
| | Electron-blocking layer 1 | HT7 | | 10 |
| | Hole transport layer 1 | HT2 | | 25 |
| | Hole injection layer 1 | HT16 | | 7 |

Comparative Example 8

A tandem organic light-emitting device was produced as in Comparative Example 1, except that Li was used as the n-dopant, and LT80 was evaluated. Examples 48 to 52

Tandem organic light-emitting devices were produced as in Example 46, except that the second electron transport material was changed, and LT80 was evaluated. As presented below, a similar improvement effect was observed, compared with Comparative Example 8.

Table 20

| Example | Second electron transport material | μ (electron) $cm^2/Vs$ [@$700V^{1/2}cm^{1/2}$] | LUMO | \|ΔLUMO\| | LT80 [hr] @$50mA/cm^2$ |
|---|---|---|---|---|---|
| Example 47 | ETM2-1 | $1.5\times10^{-3}$ | -3.10 | 0.03 | 600 |
| Example 48 | ETM2-6 | $1.9\times10^{-3}$ | -3.07 | 0.00 | 610 |
| Example 49 | ETM2-18 | $3.2\times10^{-3}$ | -3.08 | 0.01 | 620 |
| Example 50 | ETM2-19 | $2.2\times10^{-3}$ | -3.09 | 0.02 | 600 |
| Example 51 | ETM2-20 | $1.0\times10^{-4}$ | -2.71 | 0.36 | 450 |
| Comparative Example 8 | No | | | | 330 |

Examples 52 to 57

Tandem organic light-emitting devices in which the following second electron transport materials and fourth electron transport materials were combined as described in Table 8 were produced, except that Li was used as the n-dopant, and LT80 was evaluated.

Table 21

| Example | Second electron transport material | Fourth electron transport material | LT80 [hr] @$50mA/cm^2$ |
|---|---|---|---|
| Example 52 | ETM2-1 | ETM2-1 | 840 |
| Example 53 | ETM2-2 | ETM2-4 | 720 |
| Example 54 | ETM2-16 | ETM2-10 | 770 |
| Example 55 | ETM2-19 | ETM2-7 | 815 |
| Example 56 | ETM2-6 | ETM2-6 | 810 |
| Example 57 | ETM2-18 | ETM2-18 | 830 |

As described above, the organic light-emitting device according to an embodiment of the present disclosure contains the fused polycyclic hydrocarbon compound in the charge transport layer disposed between the first light-emitting layer and the charge generation portion, and thus has a long operating lifetime.

The embodiments described in this specification may be used in combination as appropriate. That is, an organic light-emitting device according to an embodiment of the present disclosure includes the following configurations. Configuration 1

An organic light-emitting device includes, in sequence, a first electrode, a first light-emitting layer, a charge transport layer, a charge generation portion, a second light-emitting layer, and a second electrode,
in which the charge transport layer contains a fused polycyclic hydrocarbon compound.

Configuration 2

In the organic light-emitting device described in configuration 1, the charge transport layer is in contact with the charge generation portion.

Configuration 3

In the organic light-emitting device described in configuration 1 or 2, the charge transport layer contains a first charge transport material and a second charge transport material different from the first charge transport material, and the second charge transport material is the fused polycyclic hydrocarbon compound. Configuration 4

In the organic light-emitting device described in configuration 3, the electron mobility of the first charge transport material is higher than the hole mobility of the first charge transport material.

Configuration 5

In the organic light-emitting device described in configuration 3, $|LUMO1 - LUMO2| \leq 0.1$ eV
where LUMO1 is a LUMO energy level of the first charge transport material, and LUMO2 is a LUMO energy level of the fused polycyclic hydrocarbon compound. Configuration 6
In the organic light-emitting device described in any one of configurations 1 to 3, the electron mobility of the fused polycyclic hydrocarbon compound is higher than the hole mobility of the fused polycyclic hydrocarbon compound.

Configuration 7

In the organic light-emitting device described in configuration 1, the fused polycyclic hydrocarbon compound has a structure in which phenyl, naphthyl, phenanthrenyl, chrysenyl, fluorenyl, triphenylenyl, pyrenyl, and spirofluorenyl moieties are combined.

Configuration 8

In the organic light-emitting device described in any one of configurations 1 to 7, the charge generation portion includes an n-type charge generation layer and a p-type charge generation layer, and
the n-type charge generation layer is in contact with the charge transport layer. Configuration 9
In the organic light-emitting device described in configuration 8, the n-type charge generation layer contains an n-type dopant, a third charge transport material, and a fourth charge transport material, and
the fourth charge transport material is composed of an electron transport material free of a polar skeleton.

Configuration 10

In the organic light-emitting device described in configuration 9, the fourth charge transport material is a fused polycyclic hydrocarbon compound. Configuration 11
In the organic light-emitting device described in configuration 9, the fused polycyclic hydrocarbon compound and the fourth charge transport material are composed of an identical organic compound.

Configuration 12

In the organic light-emitting device described in configuration 9, the proportion by weight of the fused polycyclic hydrocarbon compound in the charge transport layer is identical to the proportion by weight of the fourth charge transport material in the n-type charge generation layer.

Configuration 13

In the organic light-emitting device described in any one of configurations 1 to 12, the first light-emitting layer contains a first host material and a first light-emitting material, and

$\Delta LUMO > \Delta HOMO$
where ΔLUMO is a difference between a LUMO energy level of the first host material and a LUMO energy level of the first light-emitting material, and
ΔHOPM is a difference between the LUMO energy level of the first host material and a HOMO energy level of the first light-emitting material.

Configuration 14

In the organic light-emitting device described in configuration 13, the first light-emitting material in the first light-emitting layer emits blue light. Configuration 15
In the organic light-emitting device described in any one of configurations 1 to 14, the charge generation portion contains an organic compound having a LUMO energy level of -5.0 eV or less.

Configuration 16

A display apparatus includes multiple pixels, at least one of the multiple pixels including the organic light-emitting device described in any one of configurations 1 to 15, and a transistor coupled to the organic light-emitting device.

Configuration 17

A photoelectric conversion apparatus includes an optical unit including multiple lenses, an image pickup device configured to receive light passing through the optical unit, and a display unit configured to display an image captured by the image pickup device,
in which the display unit includes the organic light-emitting device described in any one of configurations 1 to 15.

Configuration 18

An electronic apparatus includes a display unit including the organic light-emitting device described in any one of configurations 1 to 15, a housing provided with the display unit, and a communication unit being disposed in the housing and communicating with an outside.

Configuration 19

A lighting apparatus includes a light source including the organic light-emitting device described in any one of configurations 1 to 15, and a light diffusion unit or an optical film configured to transmit light emitted from the light source.
Configuration 20
A moving object includes a lighting unit including the organic light-emitting device described in any one of configurations 1 to 15, and a body provided with the lighting unit.

Industrial Applicability

The organic light-emitting device according to an embodiment of the present disclosure has high luminous efficiency and excellent driving durability characteristics. Thus, when the organic light-emitting device according to an embodiment of the present disclosure is used for any of a variety of light-emitting devices, it is possible to provide a display apparatus or lighting apparatus with good light emission characteristics and excellent durability characteristics.
According to an embodiment of the present disclosure, a tandem organic light-emitting device having a long operating lifetime can be provided.
While the present disclosure has been described with reference to exemplary embodiments, it is to be understood that the disclosure is not limited to the disclosed exemplary embodiments. The scope of the following claims is to be accorded the broadest interpretation so as to encompass all such modifications and equivalent structures and functions.
An organic light-emitting device (26) includes, in sequence, a first electrode (2), a first light-emitting layer (43), a charge transport layer, a charge generation portion, a second light-emitting layer (44), and a second electrode (5). The charge transport layer contains a fused polycyclic hydrocarbon compound.

## Claims

**1.** An organic light-emitting device (26), comprising, in sequence:

a first electrode (2);
a first light-emitting layer (43);
a charge transport layer;
a charge generation portion;
a second light-emitting layer (44); and
a second electrode (5),
wherein the charge transport layer contains a fused polycyclic hydrocarbon compound.

**2.** The organic light-emitting device (26) according to Claim 1, wherein the charge transport layer is in contact with the charge generation portion.

**3.** The organic light-emitting device (26) according to Claim 1 or 2, wherein the charge transport layer contains a first

charge transport material and a second charge transport material different from the first charge transport material, and the second charge transport material is the fused polycyclic hydrocarbon compound.

**4.** The organic light-emitting device (26) according to Claim 3, wherein an electron mobility of the first charge transport material is higher than a hole mobility of the first charge transport material.

**5.** The organic light-emitting device (26) according to Claim 3, wherein $|LUMO1 - LUMO2| \leq 0.1$ eV
where LUMO1 is a lowest unoccupied molecular orbital (LUMO) energy level of the first charge transport material, and LUMO2 is a LUMO energy level of the fused polycyclic hydrocarbon compound.

**6.** The organic light-emitting device (26) according to any one of Claims 1 to 3, wherein an electron mobility of the fused polycyclic hydrocarbon compound is higher than a hole mobility of the fused polycyclic hydrocarbon compound.

**7.** The organic light-emitting device (26) according to any one of Claims 1 to 5, wherein the fused polycyclic hydrocarbon compound has a structure in which phenyl, naphthyl, phenanthrenyl, chrysenyl, fluorenyl, triphenylenyl, pyrenyl, and spirofluorenyl moieties are combined.

**8.** The organic light-emitting device (26) according to any one of Claims 1 to 7, wherein the charge generation portion includes an n-type charge generation layer and a p-type charge generation layer, and
the n-type charge generation layer is in contact with the charge transport layer.

**9.** The organic light-emitting device (26) according to Claim 8, wherein the n-type charge generation layer contains an n-type dopant, a third charge transport material, and a fourth charge transport material, and
the fourth charge transport material is composed of an electron transport material free of a polar skeleton.

**10.** The organic light-emitting device (26) according to Claim 9, wherein the fourth charge transport material is a fused polycyclic hydrocarbon compound.

**11.** The organic light-emitting device (26) according to Claim 9, wherein the fused polycyclic hydrocarbon compound and the fourth charge transport material are composed of an identical organic compound.

**12.** The organic light-emitting device (26) according to Claim 9, wherein a proportion by weight of the fused polycyclic hydrocarbon compound in the charge transport layer is identical to a proportion by weight of the fourth charge transport material in the n-type charge generation layer.

**13.** The organic light-emitting device (26) according to any one of Claims 1 to 12, wherein the first light-emitting layer contains a first host material and a first light-emitting material, and

$$\Delta LUMO > \Delta HOMO$$

where ΔLUMO is a difference between a LUMO energy level of the first host material and a LUMO energy level of the first light-emitting material, and
ΔHOPM is a difference between the LUMO energy level of the first host material and a highest occupied molecular orbital (HOMO) energy level of the first light-emitting material.

**14.** The organic light-emitting device (26) according to Claim 13, wherein the first light-emitting material in the first light-emitting layer emits blue light.

**15.** The organic light-emitting device (26) according to any one of Claims 1 to 14, wherein the charge generation portion contains an organic compound having a LUMO energy level of -5.0 eV or less.

**16.** A display apparatus (100), comprising:

multiple pixels,
at least one of the multiple pixels including:

the organic light-emitting device (26) according to any one of Claims 1 to 15, and

a transistor (18) coupled to the organic light-emitting device.

**17.** A photoelectric conversion apparatus, comprising:

an optical unit including multiple lenses;
an image pickup device configured to receive light passing through the optical unit; and
display means arranged to display an image captured by the image pickup device,
wherein the display unit includes the organic light-emitting device according to any one of Claims 1 to 15.

**18.** An electronic apparatus (1200), comprising:

a display unit (1201) including the organic light-emitting device (26) according to any one of Claims 1 to 15;
a housing (1203) provided with the display unit (1201); and
a communication unit being disposed in the housing and communicating with an outside.

**19.** A lighting apparatus (1400), comprising:

a light source (1402) including the organic light-emitting device (26) according to any one of Claims 1 to 15; and
light diffusion means (1405) or an optical film (1404) arranged to transmit light emitted from the light source (1402).

**20.** A moving object, comprising:

a lighting unit including the organic light-emitting device according to any one of Claims 1 to 15; and
a body provided with the lighting unit.

FIG. 1A

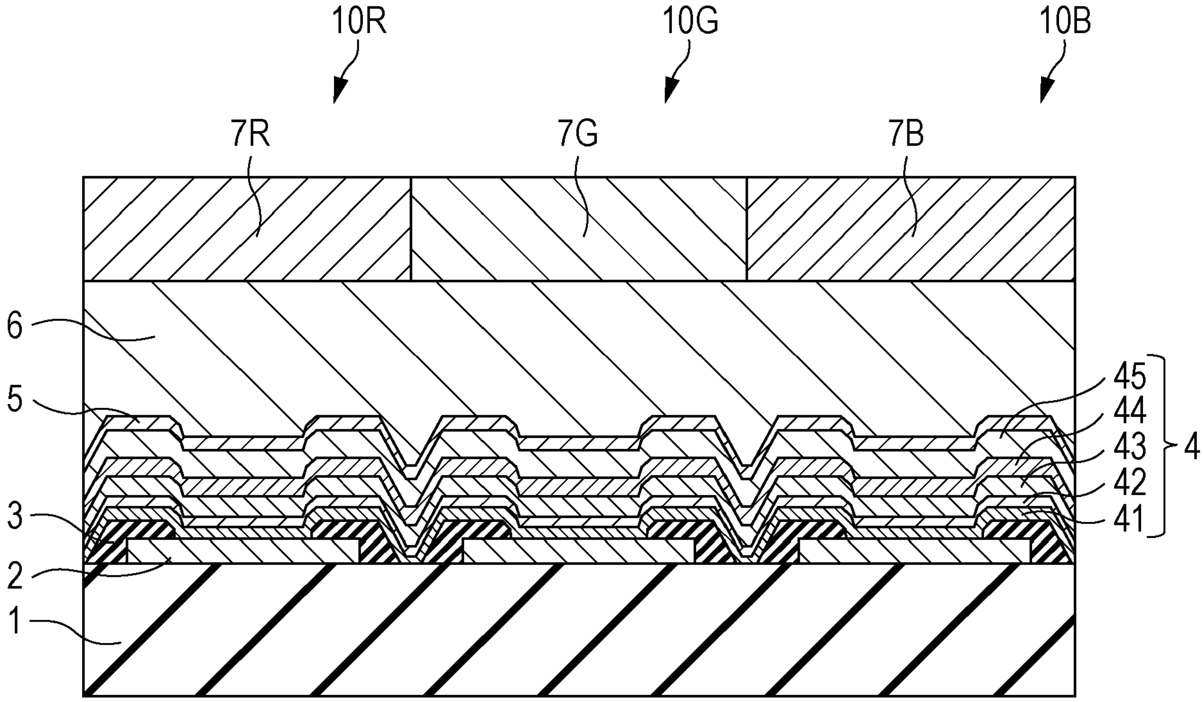
10R
10G
10B
7R
7G
7B
6
5
3
2
1
45
44
43
42
41
4

FIG. 1B

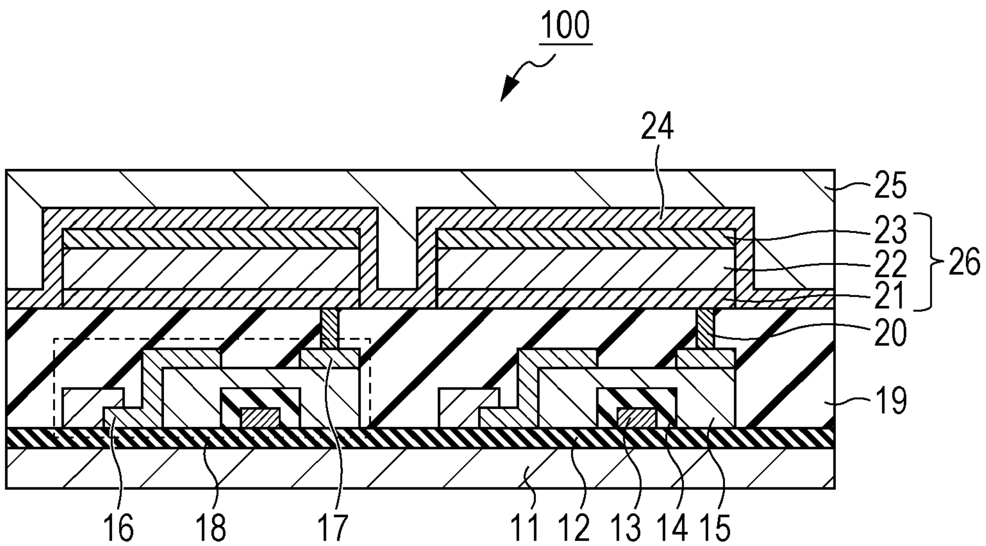
100
24
25
23
22
21
26
20
19
16
18
17
11
12
13
14
15

FIG. 2

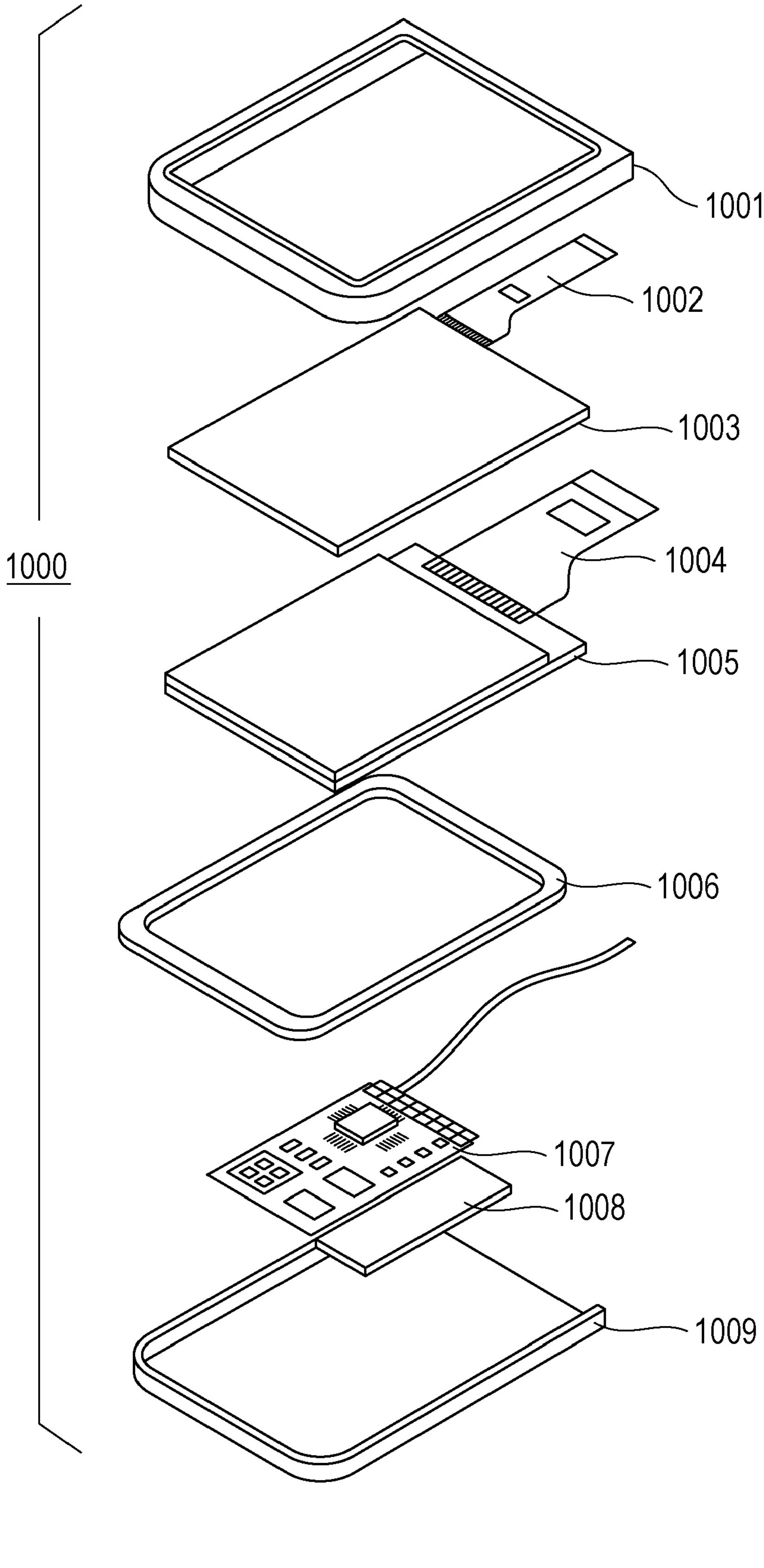

FIG. 3A

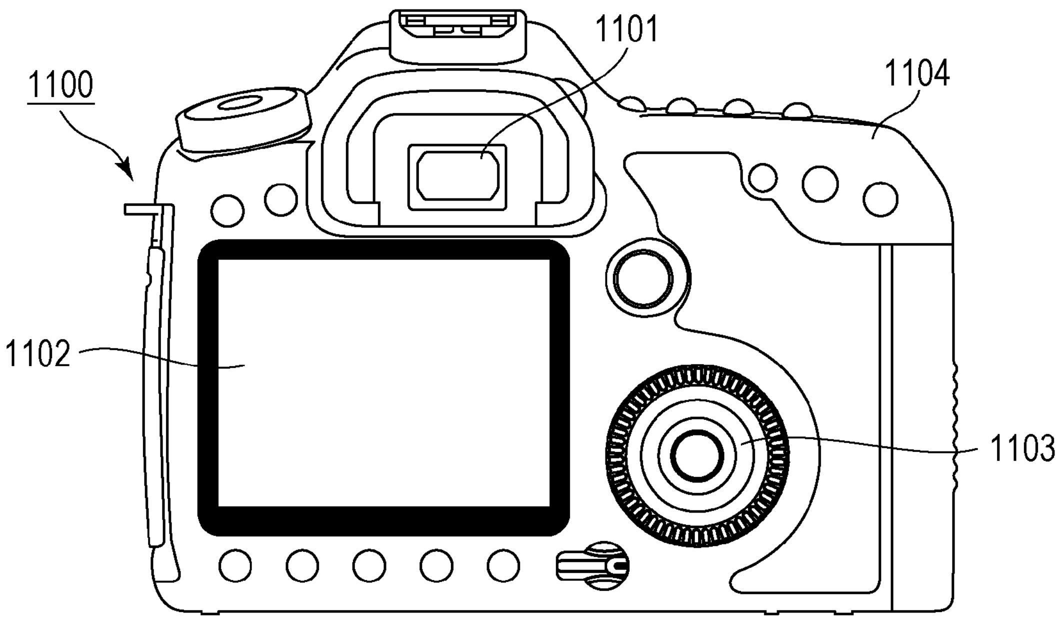


FIG. 3B

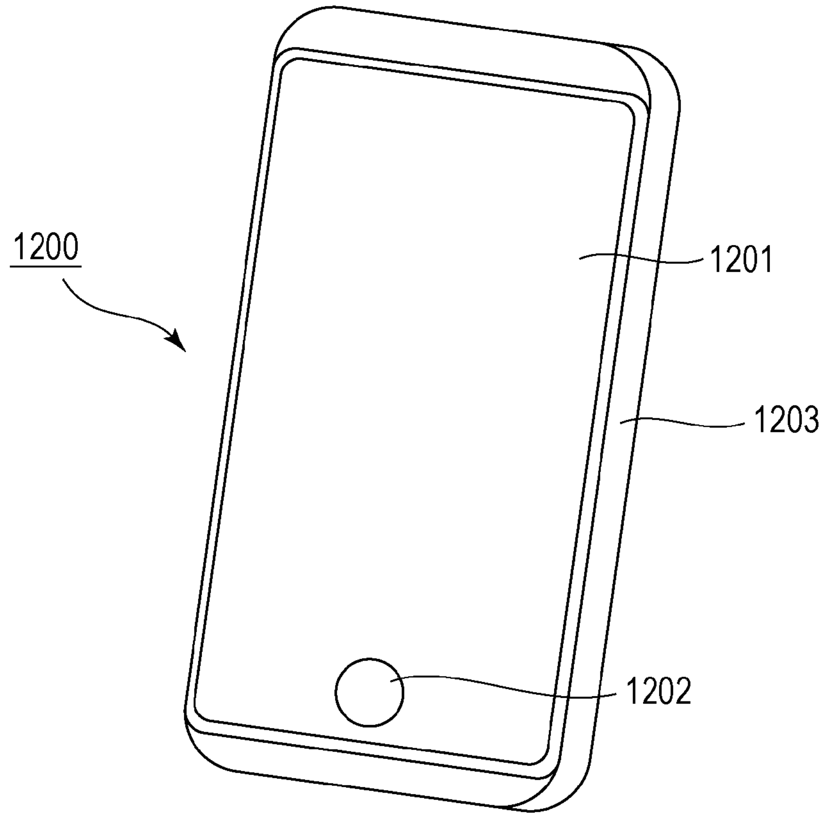

FIG. 4A

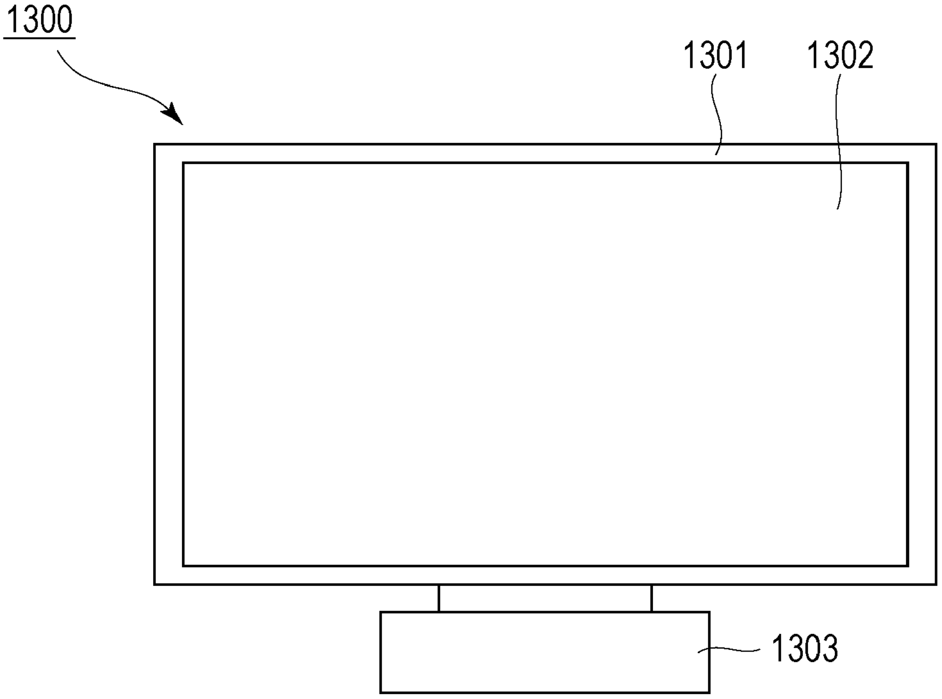


FIG. 4B

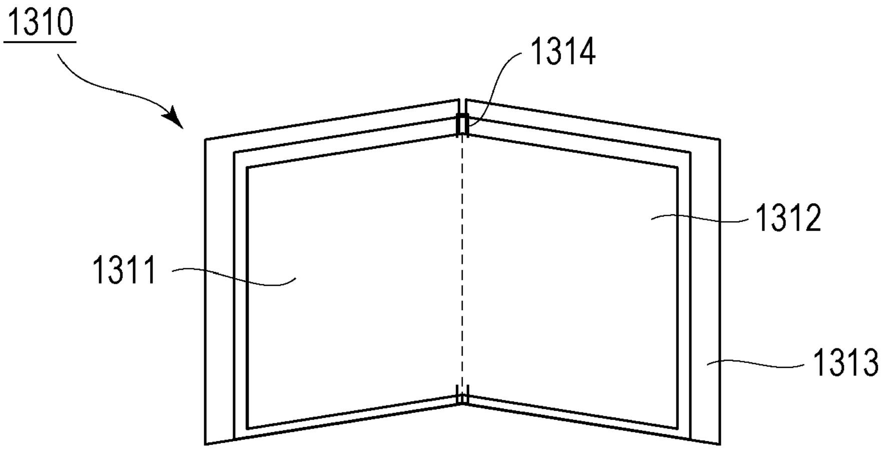

FIG. 5A

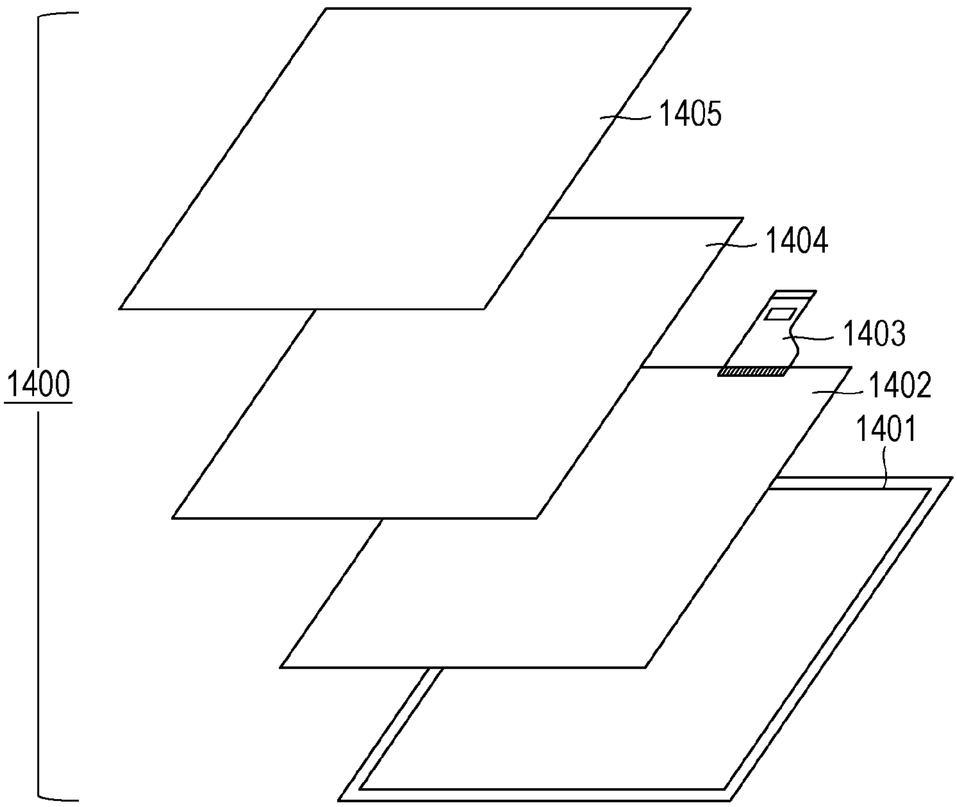


FIG. 5B

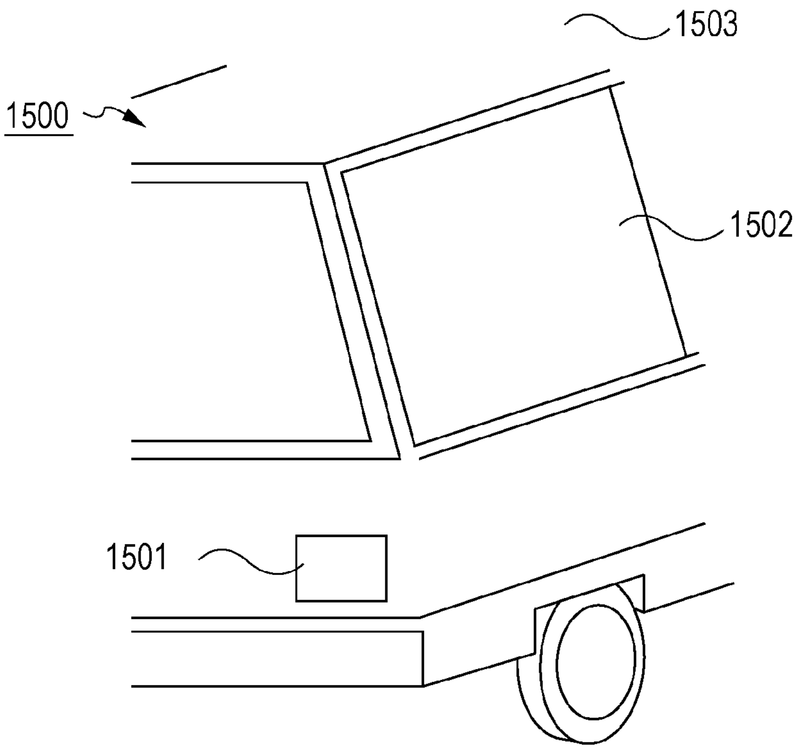

FIG. 6A

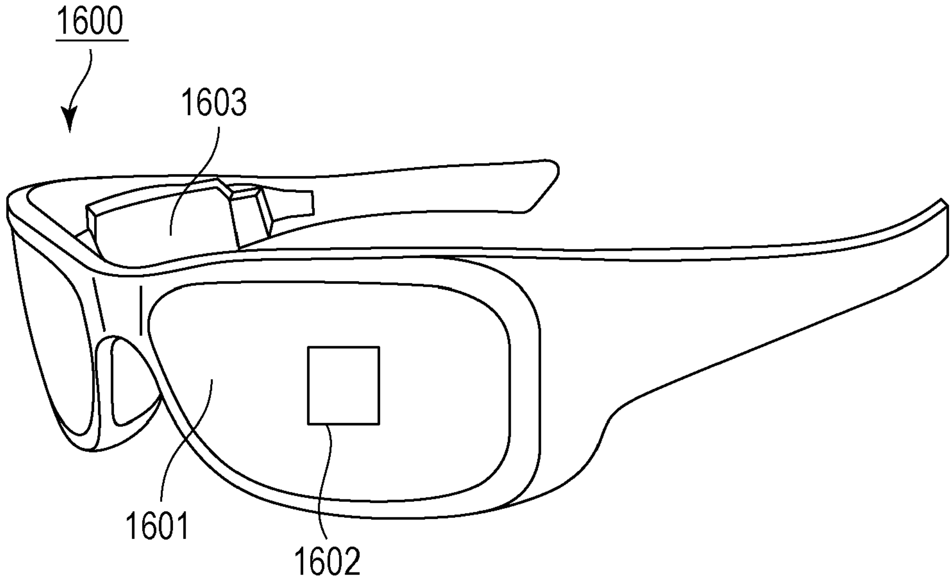


FIG. 6B

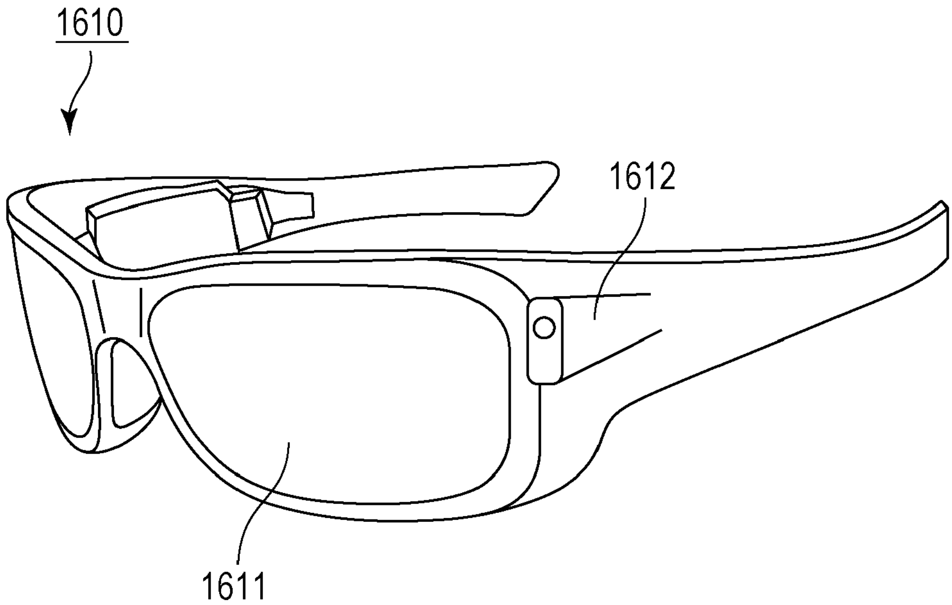

FIG. 7A

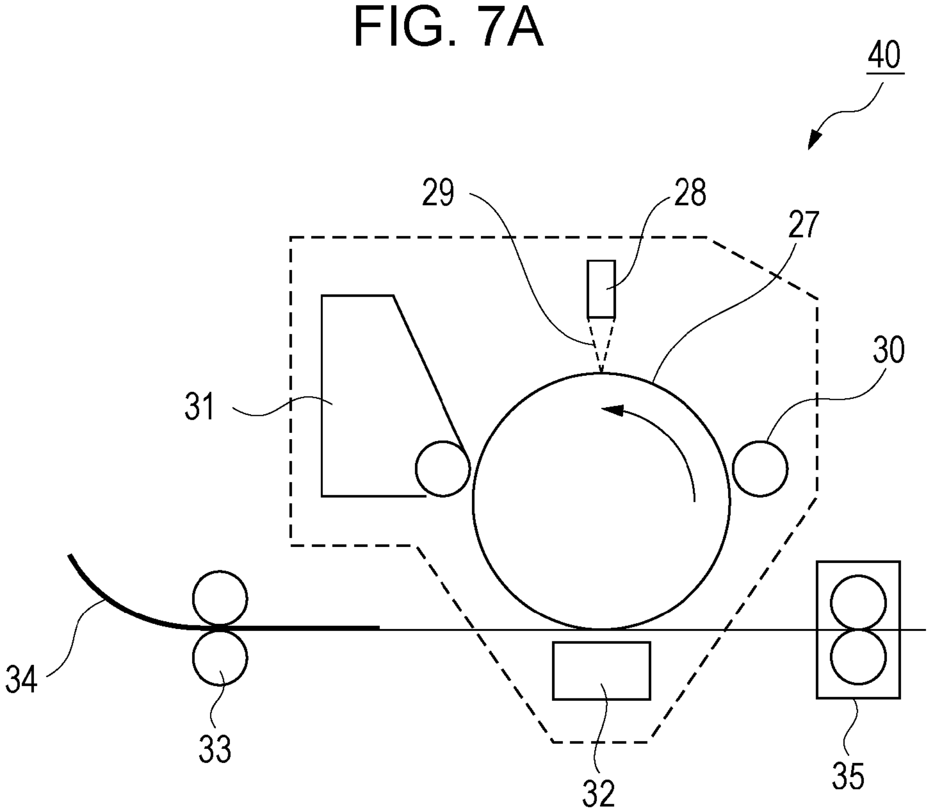


FIG. 7B

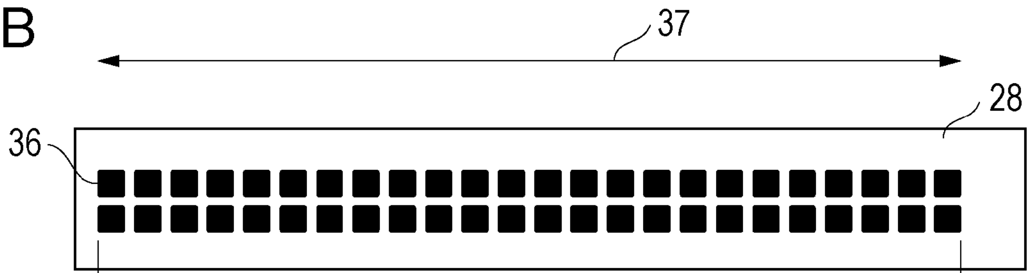


FIG. 7C

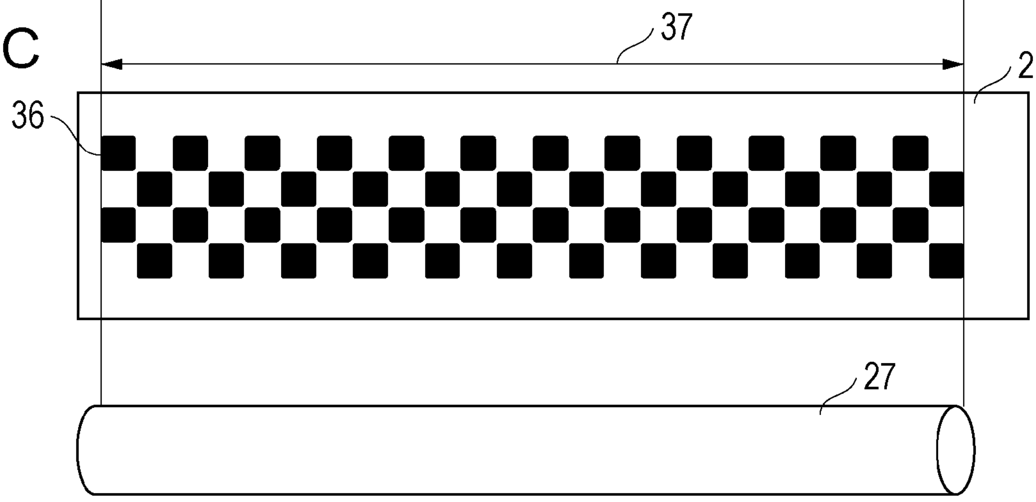

FIG. 8

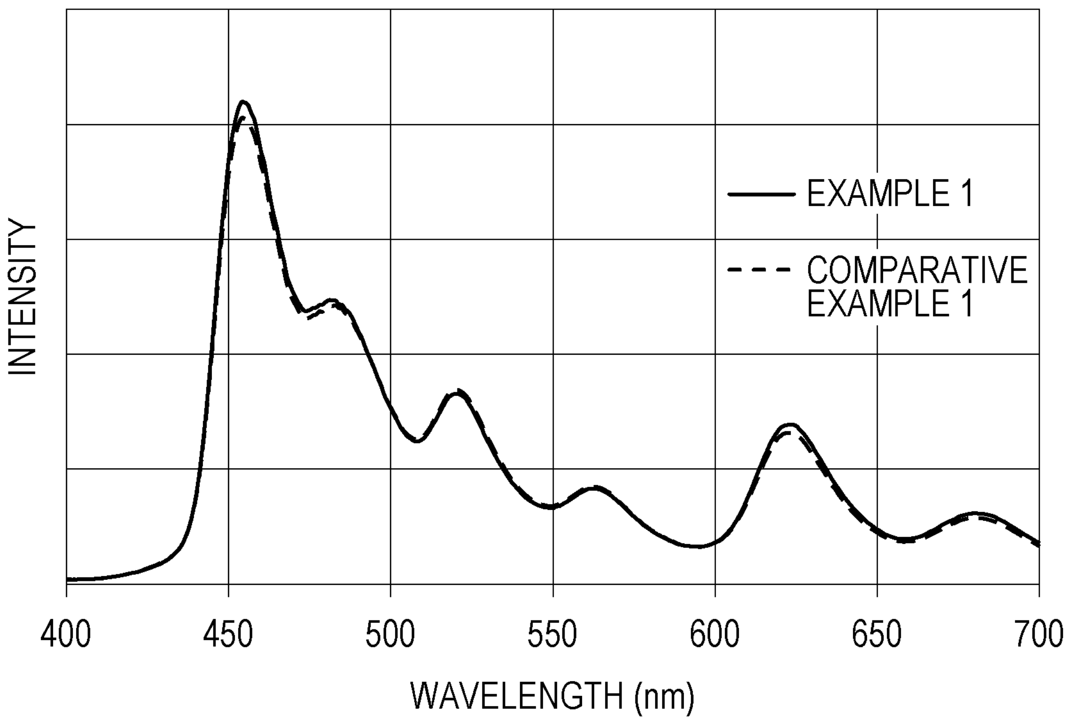
INTENSITY
EXAMPLE 1
COMPARATIVE EXAMPLE 1
400
450
500
550
600
650
700
WAVELENGTH (nm)

FIG. 9

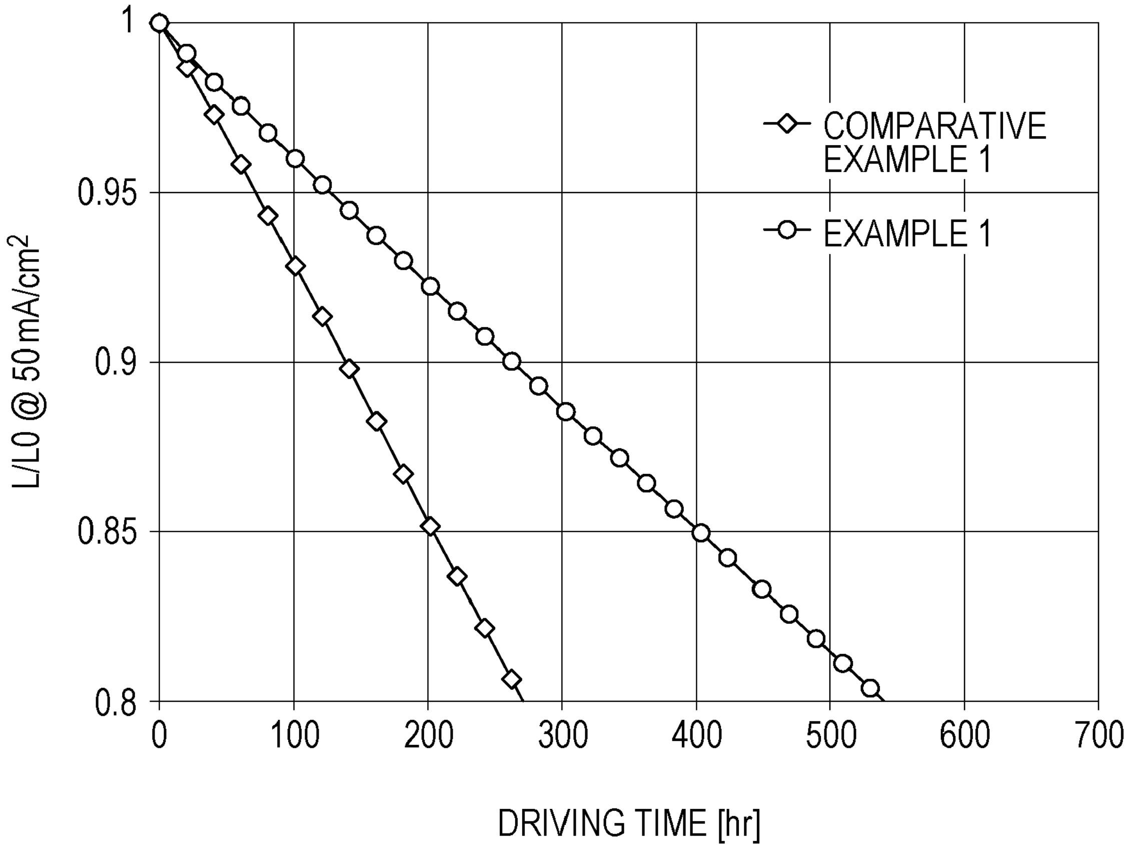
1
0.95
0.9
0.85
0.8
L/L0 @ 50 mA/cm2
0
100
200
300
400
500
600
700
DRIVING TIME [hr]
COMPARATIVE EXAMPLE 1
EXAMPLE 1

Europäisches Patentamt
European Patent Office
Office européen des brevets

# EUROPEAN SEARCH REPORT

Application Number
EP 24 15 4132

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2022/037155 A1 (KUNSHAN NEW FLAT PANEL DISPLAY TECHNOLOGY CT CO LTD [CN]) 24 February 2022 (2022-02-24)<br>* page 57, paragraph 385 - page 58, paragraph 394; example 1 *<br>----- | 1-20 | INV.<br>H10K50/165<br>H10K59/32<br><br>ADD.<br>H10K85/60 |
| X | US 2021/296606 A1 (KIM HYEONGPIL [KR] ET AL) 23 September 2021 (2021-09-23)<br>* page 20, line 27 - page 22, line 17; example 1 *<br>* page 20, line 1 - line 5 *<br>----- | 1-20 | |
| | | | TECHNICAL FIELDS SEARCHED (IPC) |
| | | | H10K |

The present search report has been drawn up for all claims

| Place of search | Date of completion of the search | Examiner |
|---|---|---|
| The Hague | 20 June 2024 | Parashkov, Radoslav |

2

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 24 15 4132

This annex lists the patent family members relating to the patent documents cited in the above-mentioned European search report. The members are as contained in the European Patent Office EDP file on
The European Patent Office is in no way liable for these particulars which are merely given for the purpose of information.

20-06-2024

| Patent document cited in search report | Publication date | Patent family member(s) | Publication date |
| --- | --- | --- | --- |
| WO 2022037155 A1 | 24-02-2022 | CN 111916573 A | 10-11-2020 |
| | | US 2023100309 A1 | 30-03-2023 |
| | | WO 2022037155 A1 | 24-02-2022 |
| US 2021296606 A1 | 23-09-2021 | KR 20210118290 A | 30-09-2021 |
| | | US 2021296606 A1 | 23-09-2021 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2015144897
- US 2015090984